(19) Europäisches Patentamt
European Patent Office
Office européen des brevets

(11) **EP 1 307 956 B1**

(12) **EUROPÄISCHE PATENTSCHRIFT**

(45) Veröffentlichungstag und Bekanntmachung des Hinweises auf die Patenterteilung:
**01.06.2005 Patentblatt 2005/22**

(21) Anmeldenummer: **01965173.6**

(22) Anmeldetag: **06.08.2001**

(51) Int Cl.$^7$: **H02H 3/38**

(86) Internationale Anmeldenummer:
**PCT/EP2001/009055**

(87) Internationale Veröffentlichungsnummer:
**WO 2002/015358 (21.02.2002 Gazette 2002/08)**

(54) **VERFAHREN UND VORRICHTUNG ZUM ORTEN VON EINPOLIGEN ERDFEHLERN**

METHOD AND DEVICE FOR LOCALISING SINGLE-POLE EARTH FAULTS

PROCEDE ET DISPOSITIF POUR LOCALISER DES DEFAUTS A LA TERRE MONOPOLAIRES

(84) Benannte Vertragsstaaten:
**AT BE CH CY DE DK ES FI FR GB GR IE IT LI LU MC NL PT SE TR**

(30) Priorität: **11.08.2000 AT 13962000**
**31.08.2000 AT 14952000**

(43) Veröffentlichungstag der Anmeldung:
**07.05.2003 Patentblatt 2003/19**

(73) Patentinhaber: **Adaptive Regelsysteme Gesellschaft mbH**
**5020 Salzburg (AT)**

(72) Erfinder: **LEIKERMOSER, Albert**
**A-5020 Salzburg (AT)**

(74) Vertreter: **VA TECH Patente GmbH & Co**
**Penzinger Strasse 76**
**1141 Wien (AT)**

(56) Entgegenhaltungen:
**EP-A- 0 963 025**

**Beschreibung**

Die Erfindung beschreibt ein Verfahren und eine Vorrichtung zum Ausführen des Verfahrens zur Ortung von einpoligen Erdfehlern in einem Abzweig oder einem Leitungsabschnitt eines sternpunktkompensierten oder sternpunktisolierten elektrischen Versorgungsnetzes, bei welchem eine Sternpunkt-Verlagerungsspannung zwischen Sternpunkt des Versorgungstransformators und Erde, beziehungsweise eine der Stempunkt-Verlagerungsspannung proportionale Messgröße, und ein Nullstrom, beziehungsweise eine dem Nullstrom proportionale Messgröße, jedes zu überwachenden Abzweiges oder Leitungsabschnittes des Netzes in einer geeigneten Weise gemessen werden.

Es sind einige Verfahren zur Ortung von einpoligen Erdfehlern in Mittel- und Hochspannungsnetzen bekannt. Die meisten dieser Verfahren verwenden die ohmsche Komponente des Nullstromes, d.h. jene Komponente des Nullstromvektors in Richtung der Sternpunkt-Verlagerungsspannung, zur Ortung von Erdfehlem, da im stationären, d.h. eingeschwungenen, Systemzustand die von den einzelnen Phasen-Erdkapazitäten des Abzweiges verursachten kapazitiven Nullstromkomponenten von den kapazitiven bzw. induktiven Komponenten des eventuell im Nullstrom enthaltenen Fehlerstromes nicht mehr unterscheidbar sind. Allerdings sind diese ohmsche Komponenten sehr klein im Verhältnis zu den kapazitiven und induktiven Anteilen, womit es schwierig wird hochohmige Erdfehler, aufgrund der sehr kleinen ohmschen Nullstromanteile, sicher zu detektieren.

Andere Verfahren verwenden die Phasenbeziehung zwischen Nullstrom und Sternpunkt-Verlagerungsspannung zur Ortung von Erdfehlem, wie beispielsweise die EP 963 025. Hier werden die Nullströme jedes zu überwachenden Abzweiges und die Stempunkt-Verlagerungsspannung gemessen und anhand der Phasenlage der gemessenen Größen festgestellt ob ein Abzweig fehlerhaft oder fehlerfrei ist.

Die Erfindung stellt sich das Ziel, ein Verfahren der eingangs genannten Art zu schaffen, welches mit einfachen Mitteln Erdfehler in Mittel- und Hochspannungsnetzen zuverlässig orten kann.

Diese Aufgabe wird für das Verfahren vorrangig dadurch gelöst, dass die Messwerte der Sternpunkt-Verlagerungsspannung und der Nullströme zu vorbestimmten Zeitpunkten digitalisiert werden und die Messwerte in digitaler Form in zumindest einen elektronischen Speicher abgelegt werden und dass die gespeicherten Messwerte von zumindest einer Messung vor und zumindest einer Messung nach einem Fehlereintritt mit einem geeigneten mathematischen Verfahren zur Ortung von einpoligen Erdfehlem ausgewertet werden. Für die Vorrichtung wird die Aufgabe dadurch gelöst, dass zumindest ein Analog/Digital-Wandler vorgesehen ist, der die Messwerte zu bestimmten Zeitpunkten in eine digitale Form umwandelt, dass zumindest ein elektronischer Speicher zum Speichern der digitalisierten Messwerte vorgesehen ist und dass eine Auswerteeinheit vorgesehen ist, die zum Ausführen eines geeigneten mathematischen Verfahrens zur Ortung von einpoligen Erdfehlem anhand von Messwerten von zumindest einer Messung vor und zumindest einer Messung nach einem Fehlereintritt geeignet ist.

Dadurch, dass die Messwerte in digitaler Form vorliegen und abgespeichert werden, ist es möglich das transiente Einschwingverhalten des Nullstromes und der Sternpunkt-Verlagerungsspannung nach dem Eintritt eines Erdfehlers zu analysieren. Dieses Verfahren ist in der Lage, die kapazitiven von den induktiven Anteilen der Nullströme der Abzweige oder Leitungsabschnitte des Netzes zu trennen und ist aufgrund dieser Eigenschaft befähigt, Aussagen über die Fehlerhaftigkeit im Zusammenhang mit einpoligen Erdfehlem auf Abzweigen oder Leitungsabschnitten durchzuführen. Da diese kapazitiven und induktiven Nullstromanteile sehr viel größer sind wie die ohmschen Nullstromanteile erlaubt diese Methode eine besonders sensible und zuverlässige Ortung von Erdfehlern.

Als ganz besonders vorteilhaft erweist es sich, wenn der funktionelle Zusammenhang des Verhaltens des Nullstromes $i_0^{(k)}$ jedes zu überwachenden Abzweiges oder Leitungsabschnittes $k$ des Netzes und der Stempunkt-Verlagerungsspannung $U_{ne}$ sowohl für den Fall der Fehlerfreiheit, als auch für den Fehlerfall durch eine lineare Differentialgleichung oder Differenzengleichung zweiter oder höherer Ordnung, beziehungsweise durch deren zugehörige äquivalente Gleichung in integraler Form, vorzugsweise in deren numerischer Schreibweise $S_i(n)=a_1 S_1(n)+a_2 S_2(n)+a_3 S_3(n)[+... + a_m S_m(n)]$, beschrieben wird. Dadurch, dass sich der Fehlerfall vom Fall der Fehlerfreiheit nur durch die Koeffizienten der Differentialgleichung unterscheidet, kann durch Bestimmen dieser Koeffizienten sehr einfach ein fehlerhafter Abzweig geortet werden.

Das Verfahren kann vereinfacht werden, indem die Stempunkt-Verlagerungsspannung $U_{ne}$ und die Nullströme $i_0^{(k)}$ zu äquidistanten Zeitpunkten $T$, entsprechend einer vorgegebenen Abtastfrequenz $f_A$, mit $T = \frac{1}{f_A}$, gemessen werden und die Abtastfrequenz $f_A$ so gewählt wird, dass sie einem ganzzahligen Vielfachen der Netzfrequenz $f_N$ entspricht.

Besonders vorteilhaft für das weitere Verfahren ist es, kontinuierlich aus den momentanen Messwerten, zum Zeitpunkt $nT$, und den entsprechenden gespeicherten Messwerten einer ganzzahligen Anzahl $j$ vorhergehender Netzperioden der Stempunkt-Verlagerungsspannung $U_{ne}$ und der Nullströme $i_0^{(k)}$ je ein Differenzwert für den Nullstrom $\Delta i^{(k)}(n)$ jedes zu überwachenden Abzweiges oder Leitungsabschnittes des Netzes und der

Stempunkt-Verlagerungsspannung $\Delta u(n)$ zu bilden und diese Differenzwerte in digitaler Form in elektronischen Speichem abzulegen, da diese Differenzwerte dann für eine weitere Verwendung zur Verfügung gestellt werden können. Diese Differenzbildung hat den Zweck, von den im Fehlerfall entstehenden transienten Signalen den stationären Signalanteil vor Fehlereintritt in Abzug zu bringen.

Ein vereinfachtes Verfahren sieht vor, dass der Differenzwert für den Nullstrom $\Delta i^{(k)}(n)$ jedes zu überwachenden Abzweiges oder Leitungsabschnittes des Netzes und/oder der Differenzwert für die Sternpunkt-Verlagerungsspannung $\Delta u(n)$ gleich der momentanen Messwerte der Nullströme $i_0^{(k)}$ bzw. der Sternpunkt-Verlagerungsspannung $U_{ne}$ zum

Zeitpunkt $nT$ gesetzt werden. Dadurch sinkt zwar die Genauigkeit des Verfahrens, sodass dieses vereinfachte Verfahren zur Ortung von hochohmigen Erdfehlern weniger gut geeignet ist. Jedoch ist im Falle eines Erdfehlers der stationäre Signalanteil relativ zum momentanen Messwert relativ klein, sodass vor allem zur Ortung von nieder- oder mittelohmigen Erdfehlern von einer Subtraktion des stationären Signalanteils abgesehen werden kann. Bei der Anwendung dieses vereinfachten Verfahrens ist auch nicht mehr zwingenderweise notwendig die Abtastfrequenz $f_A$ als ein ganzzahliges Vielfaches der Netzfrequenz $f_N$ zu wählen. Im Folgenden sind daher bei der Behandlung von Differenzwerten sowohl das weiter oben beschriebene Verfahren als auch das vereinfachte Verfahren mit der jeweiligen Definition der Differenzwerte umfasst.

Werden die Absolutbeträge der Momentanwerte der Differenzwerte $\Delta i^{(k)}(n)$ jedes zu überwachenden Abzweiges oder Leitungsabschnittes und $\Delta u(n)$ mit vordefinierten Triggerschwellen verglichen, kann sehr einfach ein Fehlerzustand des Netzes erkannt werden, wenn durch einen oder mehreren der Absolutbeträge der Differenzwerte die zugehörige Triggerschwelle hintereinanderfolgend für eine vordefinierte Anzahl überschritten wird und/oder die Absolutbeträge der Momentanwerte der Stempunkt-Verlagerungsspannung $U_{ne}(n)$ eine vordefinierte Triggerschwelle hintereinanderfolgend für eine vordefinierte Anzahl überschreiten. Besonders vorteilhaft ist es diesen Fehlereintritt an einer Ausgabeeinheit, beispielsweise ein Ausgabekontakt oder ein elektronisches Display anzuzeigen.

Die Auswertung der Differentialgleichung kann sehr einfach numerisch durchgeführt werden, wenn aus den gespeicherten Differenzwerten $\Delta i^{(k)}(n)$ und $\Delta u(n)$ mit Hilfe einer beliebigen numerischen Integrationsmethode, beispielsweise der Trapezregel, der Simpsonregel, oder einem numerischen Integrationsverfahren höherer Ordnung, die Wertefolgen $S_i(n)$, $S_1(n)$, $S_2(n)$ und $S_3(n)$, wobei der Index n den Wert der jeweiligen Wertefolge zum Zeitpunkt nT und der Index 0 den Zeitpunkt des Fehlereintrittes bezeichnet, der vier Funktionen $S_i(t)$, $S_1(t)$, $S_2(t)$ und $S_3(t)$ ermittelt werden. Diese berechneten Wertefolgen werden für die weitere Verwendung sinnvollerweise abgespeichert.

Die Analyse des Fehlerzustandes des Netzes lässt sich ganz besonders einfach mithilfe dieser linearen Differentialgleichung beziehungsweise Differenzengleichung zweiter Ordnung durch Bestimmung ihrer konstanten Koeffizienten $a_1$, $a_2$ und $a_3$, bis gegebenenfalls $a_m$, durchführen, wenn man dafür die Koeffizienten $a_1$, $a_2$ und $a_3$ durch eine beliebige Methode, vorzugsweise durch eine Methode im Zeitbereich, oder im Bildbereich einer beliebigen Transformation, beispielsweise der Z-Transformation, so bestimmt, dass die Differentialgleichung oder Differenzengleichung bzw. eine äquivalente Gleichung in integraler Form für den funktionellen Zusammenhang von Nullstrom $i_0^{(k)}$ eines überwachten Abzweiges oder Leitungsabschnittes $k$ und der Sternpunkt-Verlagerungsspannung $U_{ne}$ bestmöglich erfüllt wird. Ein besonders einfaches und schnell durchführbares Verfahren erhält man, wenn für zumindest einen zu überwachenden Abzweig oder Leitungsabschnitt des Netzes die Koeffizienten $a_1$, $a_2$ und $a_3$ aus einem linearen Gleichungssystem dritter Ordnung, $\underline{C} \cdot \underline{a} = \underline{b}$, berechnet werden.

Besonders einfache und schnell durchführbare Fehlererkennungskriterien ergeben sich durch Analyse der Koeffizienten in der Art, dass ein überwachter Leitungsabschnitt oder Abzweig als fehlerhaft erkannt wird, wenn die zugehörigen Koeffizienten $a_1$ und/oder $a_2$ negativ oder kleiner einer vordefinierten Schwelle sind und als fehlerfrei erkannt wird, wenn die zugehörigen Koeffizienten $a_1$ und/oder $a_2$ positiv oder größer einer vordefinierten Schwelle sind und dass $a_3$ in einen stempunktisolierten Netz null wird. Außerdem kann sehr einfach eine fälschlicherweise als Fehler detektierte Schalthandlung als ein Zuschalten oder Wegschalten eines Abzweiges oder Leitungsabschnittes des Netzes erkannt werden, wenn alle Messwerte $U_{ne}$ und $i_0^{(k)}$ dieses Abzweiges oder Leitungsabschnittes vor beziehungsweise nach dem Zeitpunkt der Schalthandlung im Wesentlichen Null sind.

Das Ende des Fehlerzustandes im Netz kann sehr einfach erkannt werden, wenn der Effektivwert oder Absolutbetrag der Sternpunkt-Verlagerungsspannung $U_{ne}$ eine vordefinierte Fehlerfrei-Schwelle für eine vorgegebene Zeit unterschreitet und es ist vorteilhaft nach dem Erkennen des Endes des Fehlerzustandes das Verfahren fortzusetzen.

Eine wesentliche Vereinfachung des Verfahrens ergibt sich, wenn die digitalisierten Messwerte der Sternpunkt-Verlagerungsspannung $U_{ne}$ und der Nullströme $i_0^{(k)}$ sequentiell in je einen, vorzugsweise ringförmig organisierten, elektronischen Speicher der Länge M abgelegt werden, da dann bestimmte Messwerte besonders einfach wieder aufgefunden werden können. Außerdem werden durch den ringförmigen Speicher nur eine begrenzte Anzahl von Messwerten abgespeichert, wodurch Speicherplatz eingespart werden kann. Wird zusätzlich noch die Länge M des ringförmigen Speichers so gewählt, dass sie einem ganzzahligen Vielfachen des Quotienten aus Abtastfrequenz $f_A$ und Netzfrequenz $f_N$ entspricht, lassen sich die Messwerte vorangegangener Perioden besonders leicht im Speicher auffinden.

Die weitere Verwendung der berechneten Differenzwerte wird vereinfacht, wenn die berechneten Differenzwerte $\Delta i^{(k)}(n)$ und $\Delta u(n)$ sequentiell in, vorzugsweise ringförmig organisierten, elektronischen Speichern der Länge N abgelegt werden und die Länge N kleiner oder gleich als die Länge M gewählt wird, da dann bestimmte Differenzwerte wieder sehr leicht aufzufinden sind.

Die Auswertung der Messwerte und der Differenzwerte vereinfacht sich, wenn nach dem Erkennen eines Fehlerzustandes nur noch genau N Differenzwerte $\Delta i^{(k)}(n)$ und $\Delta u(n)$ der Sternpunkt-Verlagerungsspannung $U_{ne}$ und der Nullströme $i_0^{(k)}$ gebildet und abgespeichert werden und danach die Messwerterfassung und die Differenzwertbildung bis zur Erkennung des Endes des Fehlerzustandes unterbrochen wird. Dadurch stellt man sicher, dass die transienten Änderungen der gemessenen Größen nach einem Fehlereintritt nicht überschrieben werden, also gespeichert bleiben und somit eine Analyse des Fehlerzustandes ermöglicht wird.

Setzt man als Auswerteeinheit einen Mikroprozessor ein, erhält man eine besonders flexible Ausführungsvariante. Es kann dadurch sehr einfach die Methode zur Ortung von Erdfehlern angepasst oder sogar verändert werden.

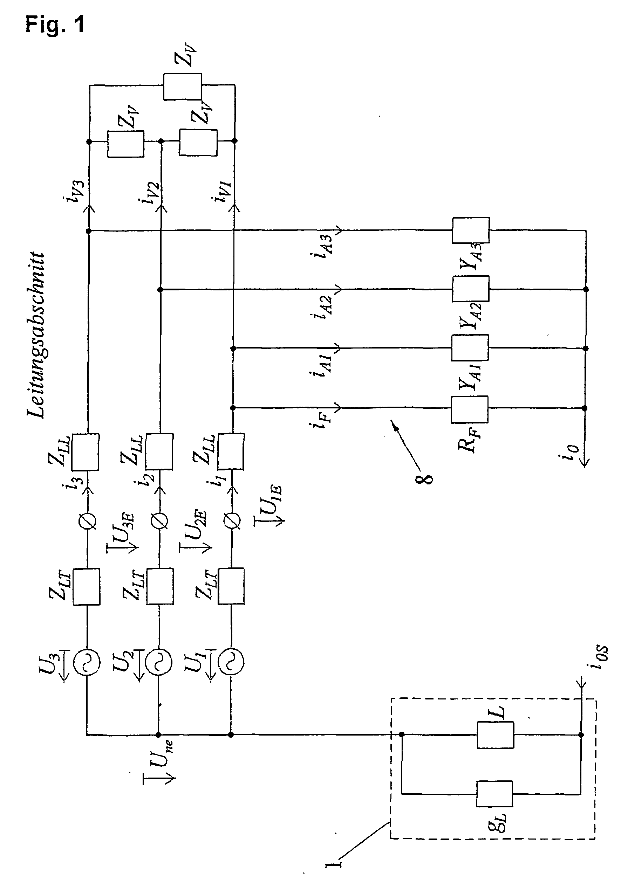

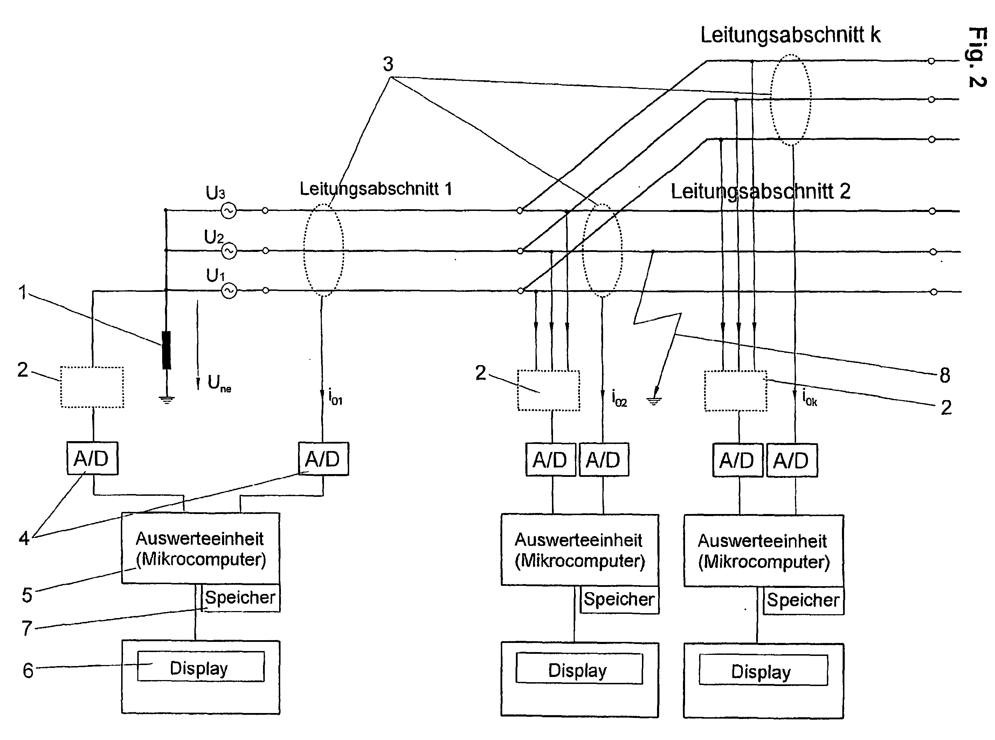

Die Erfindung wird anhand der folgenden Erläuterungen unter Bezugnahme auf die begleitenden beispielhaften und nicht einschränkenden Zeichnungen Fig. 1 und Fig. 2 näher beschrieben. In der Zeichnung zeigt

Fig. 1 das elektrische Ersatzschaltbild des Nullsystems und eines Abzweiges eines sternpunktkompensierten Netzes,

Fig. 2 eine schematische Darstellung der Messwerterfassung und Auswertung.

In Fig. 1 ist das bekannte elektrische Ersatzschaltbild eines Leitungsabschnittes eines stempunktkompensierten elektrischen Versorgungsnetzes dargestellt. Zwischen dem Transformatorsternpunkt und dem Erdungspunkt befindet sich eine Löschspule 1, die durch einen ohmschen Leitwert $g_L$ und einer Induktivität $L$ beschrieben wird. Im Fall eines sternpunktisolierten Netzes ist $g_L$ und der Kehrwert von $L$ gleich Null. Die Streuinduktivitäten sowie die ohmschen Widerstände der Sekundärwicklung des Speisetransformators werden durch die für alle drei Phasen als gleich groß angenommenen Längsimpedanzen $Z_{LT}$ repräsentiert. In das Netz, hier bestehend aus nur einem Leitungsabschnitt, werden die Phasenspannungen $U_1$, $U_2$ und $U_3$ eingespeist und es fließen die Phasenströme $i_1$, $i_2$ und $i_3$. Zwischen den drei Phasen und der Erde liegen die Phasen-Erdspannungen $U_{1E}$, $U_{2E}$ und $U_{3E}$ an.

Ein Leitungsabschnitt wird, wie für den betrachteten Frequenzbereich von <100Hz zulässig, durch Leitungslängsimpedanzen $Z_{LL}$, bestehend aus einem ohmschen und einem induktiven Term, und Leitungsableitadmittanzen $Y_{A1}$, $Y_{A2}$ und $Y_{A3}$, bestehend aus einem ohmschen und einem kapazitiven Term, beschrieben. Über die Leitungsableitadmittanzen $Y_{A1}$, $Y_{A2}$ und $Y_{A3}$ fließen die Ableitströme $i_{A1}$, $i_{A2}$ und $i_{A3}$. Eine Fehlerstelle 8 wird durch einen ohmschen Widerstand $R_F$ repräsentiert und es fließt der Fehlerstrom $i_F$. Die Ableitströme $i_{A1}$, $i_{A2}$ und $i_{A3}$ und der Fehlerstrom $i_F$ fließen als Nullstrom $i_0$ dieses Leitungsabschnittes im sternpunktkompensierten Fall über die Löschspule zum Transformatorsternpunkt zurück, während im Fall des stempunktisolierten Netzbetriebes die Ableitströme über die Fehlerstelle zurückfließen müssen. Am Erdungspunkt der Löschspule vereinigen sich die Nullströme aller vorhanden Leitungsabschnitte zur Summe der Nullströme $i_{0S}$. Verbraucherseitig, repräsentiert durch Verbraucherimpedanzen $Z_V$ fließen die Verbraucherströme $i_{V1}$, $i_{V2}$ und $i_{V3}$.

Dieses Ersatzschaltbild wird zur Herleitung von für das erfindungsgemäße Verfahren wichtigen Beziehungen verwendet.

Zu den folgenden Erläuterungen sei vorab angemerkt, dass sich die nachfolgenden Formeln, wenn nicht anders angemerkt, auf die Laplacetransformierten der jeweiligen elektrischen Größen beziehen, die vorkommenden elektrischen Größen zwecks Vereinfachung der Schreibweise jedoch nicht explizit als Funktion der komplexen Frequenzvariablen $s$ geschrieben werden, also wird beispielsweise $U_{ne}(s)$ mit $U_{ne}$ bezeichnet.

Wie aus dem elektrischen Ersatzschaltbild Fig. 1 entnommen werden kann, ergibt sich der Nullstrom $i_0$ eines beliebigen Abzweiges als sehr gute Näherung aus der Beziehung

$$i_0 = U_{ne} \cdot Y + i_f + i_v,$$

mit der Erdadmittanz $Y = (Y_{A1} + Y_{A2} + Y_{A3})$, dem Verlagerungsstrom, bzw. Unsymmetriestrom, $i_v = (U_1 \cdot \Delta Y_{A1} + U_2 \cdot \Delta Y_{A2} + U_3 \cdot \Delta Y_{A3})$, wobei die Terme $\Delta Y_{Ai}$ die Unsymmetrie der Erdadmittanzen beschreiben, und dem im Fehlerfall vorhandenen Fehlerstrom $i_f$. Für die Erdadmittanz $Y$ eines Abzweiges oder Leitungsabschnittes $k$ genügt es im betrachteten Frequenzbereich (<1 00Hz) in hinreichender Genauigkeit $Y$ durch eine Parallelschaltung der Summe der einzelnen Phasen-Erdkapazitäten $C$ und der Summe der ohmschen Leitwerte $g$ der drei Phasen gegen Erde zu repräsentieren.

$$Y^{(k)} = g^{(k)} + C^{(k)} \cdot s$$

Für die Summe der Nullströme aller Abzweige $i_{0S}$ gilt dann unter Voraussetzung, dass nur in einem der Abzweige ein Fehlerstrom vorhanden ist,

$$i_{0\,S} = U_{ne} \cdot Y_S + i_f + i_{vS},$$

wobei $Y_S$ die Summe der Erdadmittanzen aller Abzweige und $i_{vS}$ die Summe der Verlagerungsströme aller Abzweige bezeichnet. Gemäß der Beziehung für die Erdadmittanz $Y$ eines Abzweiges folgt durch Summenbildung, mit dem Summenleitwert $g_S$ aller Abzweige und der Summenkapazität $C_S$ aller Abzweige,

$$Y_S = g_S + C_S \cdot s.$$

Die Nullströme aller Abzweige $i_{0S}$ fließen dabei im stempunktkompensierten Netzbetrieb über die Löschspule zum Transformatorstempunkt zurück, wodurch folgende Beziehung aufgestellt werden kann.

$$i_{0S} = -U_{ne} \cdot Y_L$$

$Y_L$ ist die Admittanz vom Erdungspunkt der Löschspule bis zum Transformatorstempunkt und setzt sich aus einem ohmschen Leitwert $g_L$ und der Induktivität $L$ der Löschspule zusammen. Im Fall des stempunktisolierten Netzzustandes ist $Y_L$ gleich null

$$Y_L = g_L + \frac{1}{L \cdot s}$$

Durch Gleichsetzen der obigen Gleichungen für den Summennullstrom $i_{0S}$ erhält man eine Beziehung für die Sternpunkt-Verlagerungsspannung $U_{ne}$.

$$U_{ne} = -\frac{i_{vS} + i_f}{Y_S + Y_L}$$

Sei jetzt per Definition das Gesamtnetz während des mit Index (1) gekennzeichneten Zeitpunktes fehlerfrei und der Erdfehlerfall durch den Index (2) gekennzeichnet, dann gelten unter der Voraussetzung, dass sich die ohmschen Ableitungen, die Kapazitäten und die Induktivität der Löschspule 1 während dieser beiden Messzyklen nicht geändert haben und außerdem die natürlichen Verlagerungsströme aller Abzweige gleich geblieben sind unter Berücksichtigung der obigen Herleitungen die folgenden Beziehungen für die Stempunkt-Verlagerungsspannung und die Nullströme eines Abzweiges oder Leitungsabschnittes des Netzes.

$$U_{ne}^{(1)} = -\frac{i_{vS}}{Y_S + Y_L} \qquad\qquad i_0^{(1)} = U_{ne}^{(1)} \cdot Y + i_v$$

$$U_{ne}^{(2)} = -\frac{i_{vS} + i_f^{(2)}}{Y_S + Y_L} \qquad\qquad i_0^{(2)} = U_{ne}^{(2)} \cdot Y + i_v + i_f$$

Durch elementare Umformung dieser Gleichungen erhält man unmittelbar einen Zusammenhang zwischen den Differenzen der Sternpunkt-Verlagerungsspannungen und der Nullströme vor und nach einem Fehlerfall eines beliebigen Abzweiges k.

$$\left( i_0^{(2)} - i_0^{(1)} \right) = F(s) \cdot \left( U_{ne}^{(2)} - U_{ne}^{(1)} \right)$$

*oder*

$$\Delta i(s) = F(s) \cdot \Delta u(s)$$

Die Übertragungsfunktion $F(s)$ ist dabei für einen fehlerhaften Abzweig durch

$$F(s)=(Y\text{-}Y_S\text{-}Y_L)=a_1+a_2\cdot s+\frac{a_3}{s}$$

*mit* :

$$a_1 = g^{(k)}\text{-}g_S\text{-}g_L$$

$$a_2 = C^{(k)}\text{-}C_S$$

$$a_3 = \text{-}\frac{1}{L}$$

und für einen fehlerfreien Abzweig durch

$$F(s)=Y=a_1+a_2\cdot s$$

*mit :*
$a_1 = g^{(k)}$
$a_2 = C^{(k)}$ gegeben. Durch entsprechende andere Annahmen und Erweiterungen des Modells bei der Herleitung des obigen Zusammenhanges ist es natürlich auch möglich, Differential- bzw. Differenzengleichungen höherer Ordnungen, beziehungsweise in äquivalenter integraler Form, $S_i(n)=a_1 S_1(n)+a_2 S_2(n)+a_3 S_3(n)+...+a_m S_m(n)$, zu erhalten und die weiteren Auswertungen anhand dieser Gleichungen durchzuführen.

Wie man sieht, unterscheidet sich die Übertragungsfunktion F($s$) für den fehlerfreien Fall vom Fehlerfall nur durch die Koeffizienten $a_1$, $a_2$ und $a_3$. Dadurch ist es möglich aufgrund der Werte der Koeffizienten $a_1$, $a_2$ und $a_3$ Aussagen darüber zu treffen, ob ein Abschnitt k des Netzes fehlerfrei oder fehlerbehaftet ist, da direkt einsichtlich folgendes gelten muss.

$a_1$, $a_2 < 0 \Rightarrow$ der betrachtete Abschnitt k des Netzes ist fehlerhaft, da von dem abzweigspezifischen Leitwert $g^{(k)}$ und der abzweigspezifischen Kapazität $C^{(k)}$ zumindest jene des Gesamtnetzes abgezogen werden.

$a_1$, $a_2 > 0 \Rightarrow$ der betrachtete Abschnitt k des Netzes ist fehlerfrei, da nur der abzweigspezifische Leitwert $g^{(k)}$ und die abzweigspezifische Kapazität $C^{(k)}$ vorkommen.

$a_3 = 0 \Rightarrow$ das Netz wird sternpunktisoliert betrieben.

Das erfindungsgemäße Verfahren zur Ortung eines einpoligen Erdfehlers reduziert sich also auf die Bestimmung der Koeffizienten $a_1$, $a_2$ und $a_3$ aus dem Gleichungssystem

$$\Delta i(s) = \left( a_1 + a_2 \cdot s + \frac{a_3}{s} \right) \cdot \Delta u(s).$$

Bei Kenntnis der Sternpunkt-Verlagerungsspannungsdifferenz $\Delta u$ und der Nullstromdifferenz $\Delta i$ als Funktionen der Zeit, können nun mit einem geeigneten Koeffizientenschätzverfahren die drei Koeffizienten $a_1$, $a_2$ und $a_3$ so bestimmt werden, dass der Gleichungsfehler obiger, in den Zeitbereich rücktransformierter Gleichung im Sinne der Bestapproximation der Summe der Gleichungsfehler über eine Anzahl von Sampies im quadratischen Mittel minimiert wird. Diese Aufgabe kann auch durch Anwendung von Methoden im Bildbereich, wie zum Beispiel geeigneten Parameterschätzverfahren auf der Grundlage der z-Transformation oder Bilineartransformation gelöst werden. Natürlich können all diese Methoden auch auf integrale Formen obiger Gleichungen zur Anwendung gebracht werden. Insbesondere wird hier stellvertretend eine Methode zur Bestimmung der Koeffizienten $a_1$, $a_2$ und $a_3$ vorgestellt.

Die Beziehung zwischen den Nullstromdifferenzen und den Stempunkt-Verlagerungsspannungsdifferenzen beziehungsweise zwischen den Nuttströmen und der Verlagerungsspannung vor und nach dem Eintreten eines Erdfehlers gemäß der obigen Gleichung wird zuerst mit dem Kehrwert der komplexen Frequenzvariable s multipliziert und anschließend in den Zeitbereich zurücktransformiert, wodurch sich im Zeitbereich folgender Zusammenhang ergibt.

$$S_i(t) = a_1 S_1(t) + a_2 S_2(t) + a_3 S_3(t)$$

*mit*:

$$S_i(t) = \int_0^t \Delta i(\tau)\,d\tau$$

$$S_1(t) = \int_0^t \Delta u(\tau)\,d\tau$$

$$S_2(t) = \Delta u(t)$$

$$S_3(t) = \int_0^t \left( \int_0^\sigma \Delta u(\tau)\,d\tau \right) d\sigma$$

Bei der Anwendung von Gleichungen höherer Ordnung, ergeben sich entsprechende weitere Funktionen $S_4(t),...,S_m(t)$ und zugehörige Koeffizienten $a_4,...,a_m$, die zur Analyse des Fehlerzustandes entsprechend ausgewertet werden müssen.

Das erfindungsgemäße Verfahren wird im folgenden anhand der beispielhaften Fig. 2 beschrieben. Aufgrund der numerischen Funktionsweise des Verfahrens ist es notwendig, die Zeitfunktionen der Sternpunkt-Verlagerungsspannung $U_{ne}(t)$ sowie des Nullstromes $i_0(t)$ jedes zu überwachenden Abzweiges oder Leitungsabschnittes des Netzes zu äquidistanten Zeitpunkten, entsprechend einer Abtastzeit $T = \frac{1}{f_A}$ mit der Abtastfrequenz $f_A$, zu digitalisieren und in Form von Messwertfolgen $U_{ne}(nT)$, oder in einfacher Schreibweise $U_{ne}(n)$, und $i_0(nT)$, oder in einfacher Schreib- weise $i_0(n)$, in einem Speicher 7 zu speichern. Dazu werden die Sternpunkt-Verlagerungsspannung $U_{ne}(n)$, bzw. eine der Sternpunkt-Verlagerungsspannung proportionalen Messgröße, und der Nullstrom $i_0(n)$ jedes zu überwachenden Abzweiges oder Leitungsabschnittes mit einer Spannungsmesseinheit 2 beziehungsweise mit Strommesseinheiten 3 gemessen und mittels Analog/Digital-Wandlem 4 digitalisiert. Die Abtastfrequenz $f_A$ wird dabei vorzugsweise als ein ganzzahliges Vielfaches der Netzfrequenz $f_N$ gewählt. Aus diesen Messwertfolgen können nun in einfacher Weise Messwertdifferenzen gebildet werden, wobei immer der gespeicherte Messwert eines ganzzahligen Vielfachen von vorhergehenden Netzfrequenzperioden vom momentanen Messwert abgezogen wird, also im Fehlerfall der Messwert vor dem Eintritt des Fehlers vom Messwert im Fehlerfall, gemäß der oben angeführten Beziehungen, und die so ent- stehenden Messwertdifferenzfolgen $\Delta u(n)$ und $\Delta i(n)$ ebenfalls abgespeichert werden. Dazu ist es günstig, dass die Speicher 7 als ringförmige Speicher organisiert werden und die Länge der Messwertspeicher M genau einem ganzzahligen Vielfachen des Quotienten aus Abtastfrequenz $f_A$ und Netzfrequenz $f_N$ entspricht, da es dann sehr einfach ist den Messwert eines ganzzahligen Vielfachen einer vorhergehenden Periode aufzufinden. Diese Messwerterfassung wird solange kontinuierlich durchgeführt, bis ein Erdfehler 8 erkannt wird. Dieser Fehlereintritt ist durch eine plötzliche Änderung von $\Delta u(t)$ und/oder $\Delta i(t)$ zu erkennen, da im fehlerfreien stationären Zustand des Netzes beide Größen annähernd Null sein müssen. Zur Erkennung von nieder- oder mittelohmigen Erdfehlern kann das erfindungsgemäße Verfahren statt mit den Differenzwerten $\Delta u(t)$ und $\Delta i(t)$ auch mit den Messwerten Sternpunkt-Verlagerungsspannung $U_{ne}(n)$ und Nullstrom $i_0(n)$ selbst durchgeführt werden. Dabei muss die Abtastfrequenz $f_A$ nicht mehr zwingendermaßen einem ganzzahligen Vielfachen der Netzfrequenz $f_N$ entsprechen.

Bei Fehlereintritt werden die Messwertdifferenzen mit vordefinierten Triggerschwellen verglichen und an der Anzeigeeinrichtung 6 ein Fehler angezeigt, wenn eine vorgegebene Anzahl der Absolutbeträge der Differenzen hintereinanderfolgend die zugehörige Triggerschwelle überschreiten und/oder die Absolutbeträge der Momentanwerte der Sternpunkt-Verlagerungsspannung $U_{ne}(n)$ eine vordefinierte Triggerschwelle hintereinanderfolgend für eine vordefinierte Anzahl überschreiten. Nach dem Erkennen eines Erdfehlers 8 werden noch genau N Differenzen von Messwerten gebildet und abgespeichert, wobei gilt N<M.

Aus diesen N Messwertdifferenzen lassen sich in der Auswerteeinheit 5 die zugehörigen Integrale als Funktion der Zeit durch numerische Integration, z.B. mit Hilfe der Trapez- oder Simpsonregel, in einfacher Weise berechnen. Begonnen wird mit den numerischen Integrationen zum Zeitpunkt t=0, also bei Fehlereintritt. Somit reduziert sich das mathematische Problem darauf, mit Hilfe der nun bekannten Funktionen $S_1(t)$, $S_2(t)$, $S_3(t)$ und $S_i(t)$, bzw. deren nume-risch ermittelten Wertefolgen $S_1(n)$, $S_2(n)$, $S_3(n)$ und $S_i(n)$, unter Verwendung der Differentialgleichung bzw. Differenzengleichung 2. Ordnung in deren integralen Form für jeden überwachten Abzweig oder Leitungsabschnitt des Netzes die noch unbekannten Koeffizienten $a_1$, $a_2$ und $a_3$ so zu bestimmen, dass die Gleichheit der linken und rechten Seite der obigen Gleichung über eine vorgegebene Anzahl von Samples bestmöglich erfüllt wird. Es lässt sich zeigen, dass sich die Koeffizienten $a_1$, $a_2$ und $a_3$ aus einem linearen Gleichungssystem dritter Ordnung bestimmen lassen und die so bestimmten Koeffizienten bestapproximierend bezüglich der Minimierung der Summe der Fehlerquadrate der Gleichungsfehler sind. Durch Lösen des linearen Gleichungssystemes

$$\underline{\underline{C}} \cdot \underline{a} = \underline{b},$$

mit einem aus den drei Koeffizienten $a_1$, $a_2$ und $a_3$ bestehenden Lösungsvektor $\underline{a}$, einer 3x3 Matrix $\underline{\underline{C}}$ und einem dreidimensionalen Vektor $\underline{b}$, deren Elemente durch folgende Beziehungen ermittelt werden,

$$c_{kj} = \sum_{n=1}^{N} S_k(n) \cdot S_j(n) \qquad \forall\, k, j \in \{1,2,3\}$$

und

$$b_k = \sum_{n=1}^{N} S_i(n) \cdot S_k(n) \qquad \forall\, k \in \{1,2,3\},$$

können nun die drei Koeffizienten $a_1$, $a_2$ und $a_3$ ermittelt werden.

Die Lösung dieses linearen Gleichungssystems 3. Ordnung, für jeden überwachten Abzweig oder Leitungsabschnitt des Netzes, kann wiederum mit jedem beliebigen bekannten Verfahren gefunden werden und liefert die drei Koeffizienten $a_1$, $a_2$ und $a_3$ die anschließend entsprechend der allgemeinen obigen Erläuterungen ausgewertet werden können.

Darüber hinaus können Schalthandlungen im Netz, also das Zuschalten oder Wegschalten eines Abzweiges oder Leitungsabschnittes sehr einfach festgestellt werden, da direkt ersichtlich vor beziehungsweise nach einer Schalthandlung alle Messwerte vorher beziehungsweise nachher im Wesentlichen Null sein müssen. In diesem Fall soll natürlich kein Fehlerzustand angezeigt werden.

Nach der Ortung des Erdfehlers 8 beziehungsweise einer Schalthandlung, also der Zuordnung zu einem bestimmten Abzweig oder Leitungsabschnitt des Netzes, gemäß der zugehörigen Koeffizienten $a_1$, $a_2$ und $a_3$, wird das Ende des Fehlerzustandes abgewartet und wieder mit der Messwerterfassung begonnen. Das Ende des Fehlerzustandes erkennt man durch Messung und Überwachung der Sternpunkt-Verlagerungsspannung, wobei die Fehlermeldung zurückgenommen wird, wenn die Sternpunkt-Verlagerungsspannung eine vordefinierte Fehlerfrei-Schwelle unterschreitet.

Die Beschreibung des erfindungsgemäßen Verfahrens ist lediglich beispielhaft und in keiner Weise einschränkend. Insbesondere sind alle einem Fachmann bekannten Methoden zur Ermittlung der Koeffizienten $a_1$, $a_2$ und $a_3$ äquivalent einsetzbar.

Aufgrund der technischen Auslegung der Löschspule ist es möglich, dass während des transienten Einschwingens des Gesamtnetzes nach dem Auftreten eines Erdfehlers in der Löschspule magnetische Sättigungseffekte auftreten, die jedoch im obigen mathematischen Modell nicht berücksichtigt werden. Wie sich leicht zeigen lässt, kann durch die Funktion $S_1(t)$ beziehungsweise $S_1(n)$ der magnetische Sättigungszustand der Löschspule rekonstruiert werden, da aufgrund des Induktionsgesetzes eine Proportionalität zwischen der ersten Ableitung des magnetischen Flusses nach der Zeit und der Spulenspannung, also der Verlagerungsspannung, besteht. Natürlich bleibt diese Proportionalität bis auf eine additive Konstante auch für die zeitlichen Integrale der beiden Größen aufrecht. Also kann davon ausgegangen werden, dass die Änderung des magnetischen Flusses ab den Zeitpunkt des Fehlereintrittes proportional zur Änderung des Verlagerungsspannungsintegrales, also näherungsweise proportional zur Funktion $S_1(t)$ beziehungsweise $S_1(n)$ ist. Wird nun der Approximationsprozess, beginnend beim Zeitpunkt Null, also bei Fehlereintritt, nur bis zu jenem Zeitpunkt durchgeführt, bei dem der Absolutbetrag der Funktion $S_1(t)$ beziehungsweise $S_1(n)$ größer als eine vordefinierte Sättigungsschwelle wird, so kann davon ausgegangen werden, dass nur die Messwerte jener Prozesszustände zur Auswertung gelangen, bei denen sichergestellt ist, dass die Löschspule nicht magnetisch gesättigt und daher das unterstellte mathematische Modell korrekt ist.

Außerdem liegt es im Bereich der Erfindung anstatt einer lokalen Messwerterfassung und Messwertauswertung für jeden Leitungsabschnitt, wie in Fig. 2 dargestellt, diese zentral an einer beliebigen Stelle des Netzes, anzuordnen, d.h. es ist nur eine Auswerteeinheit, ein Speicher und ein Display vorgesehen. Dabei wird die Sternpunkt-Verlagerungsspannung $U_{ne}$ (t) zum Beispiel am Stempunkt des Speisetransformators gegen Erde oder durch Summenbildung der drei Phasen - Erdspannungen gemessen und digitalisiert der Auswerteeinheit zugeführt. Die Nullströme werden nach wie vor für jeden Leitungsabschnitt gemessen und beispielsweise digital zur Auswerteeinheit übertragen. Die Auswertung des Zustandes jedes einzelnen erfassten Leitungsabschnittes erfolgt dann nach dem oben beschriebenen Verfahren in der Auswerteeinheit. Ebenso sind natürlich auch beliebige Kombinationen zwischen lokaler und zentraler Messwerterfassung und Messwertauswertung durch die Erfindung erfasst.

Weiters liegt die Anordnung und die Anzahl der verwendeten A/D-Wandler im Ermessen eines Fachmannes. Insbesondere ist es auch denkbar Mikrocomputer mit bereits integrierten A/D-Wandlern zu verwenden.

## Patentansprüche

1. Verfahren zur Ortung von einpoligen Erdfehlem in einem Abzweig oder einem Leitungsabschnitt eines stempunktkompensierten oder stempunktisolierten elektrischen Versorgungsnetzes, bei welchem eine Sternpunkt-Verlagerungsspannung $U_{ne}$, beziehungsweise eine der Sternpunkt-Verlagerungsspannung $U_{ne}$ proportionale Messgröße, und ein Nullstrom $i_0^{(k)}$, beziehungsweise eine dem Nullstrom $i_0^{(k)}$ proportionale Messgröße, jedes zu überwachenden Abzweiges oder Leitungsabschnittes $k$ des Netzes in einer geeigneten Weise gemessen werden, **dadurch gekennzeichnet, dass** die Messwerte der Sternpunkt-Verlagerungsspannung $U_{ne}$ und der Nullströme $i_0^{(k)}$ zu vorbestimmten Zeitpunkten digitalisiert werden und die Messwerte in digitaler Form in zumindest einen elektronischen Speicher abgelegt werden **und dass** die gespeicherten Messwerte von zumindest einer Messung vor und zumindest einer Messung nach einem Fehlereintritt mit einem geeigneten mathematischen Verfahren zur Ortung von einpoligen Erdfehlern ausgewertet werden.

2. Verfahren nach Anspruch 1, **dadurch gekennzeichnet, dass** der funktionelle Zusammenhang des Verhaltens von Abzweig- bzw. Leitungsabschnitt-Nullstrom $i_0^{(k)}$ jedes zu überwachenden Abzweiges oder Leitungsabschnittes $k$ des Netzes und der Stempunkt-Verlagerungsspannung $U_{ne}$ sowohl für den Fall der Fehlerfreiheit, als auch für den Fehlerfall durch eine lineare Differentialgleichung oder Differenzengleichung zweiter oder höherer Ordnung, beziehungsweise durch deren zugehörige äquivalente Gleichung in integraler Form, vorzugsweise in deren numerischer Schreibweise,

$$S_i(n) = a_1 S_1(n) + a_2 S_2(n) + a_3 S_3(n)[+... + a_m S_m(n)]$$

beschrieben wird **und dass** sich der Fehlerfall vom Fall der Fehlerfreiheit nur durch Koeffizienten $a_1$, $a_2$ und $a_3$, bis gegebenenfalls $a_m$, unterscheidet.

3. Verfahren nach Anspruch 1 oder 2, **dadurch gekennzeichnet, dass** die Sternpunkt-Verlagerungsspannung $U_{ne}$ und die Nullströme $i_0^{(k)}$ zu äquidistanten Zeitpunkten T, entsprechend einer vorgegebenen Abtastfrequenz $f_A$, mit $T = \frac{1}{f_A}$, gemessen werden.

4. Verfahren nach Anspruch 3, **dadurch gekennzeichnet, dass** die Abtastfrequenz $f_A$ so gewählt wird, dass sie einem ganzzahligen Vielfachen der Netzfrequenz $f_N$ entspricht.

5. Verfahren nach Anspruch 3 oder 4, **dadurch gekennzeichnet, dass** kontinuierlich aus den momentanen Messwerten, zum Zeitpunkt $nT$, und den entsprechenden gespeicherten Messwerten einer ganzzahligen Anzahl $j$ vorhergehender Netzperioden, der Stempunkt-Verlagerungsspannung $U_{ne}$ und der Nullströme $i_0^{(k)}$ nach den Beziehungen

$$\Delta i^{(k)}(n) := \left[ i_0^{(k)}(n) - i_0^{(k)}(n-m) \right] \qquad \text{mit } n \in \{0,1,2,\ldots,N\} \text{ und } m = j \cdot \left| \frac{f_A}{f_N} \right|,$$
$$\Delta u(n) := \left[ U_{ne}(n) - U_{ne}(n-m) \right]$$

je ein Differenzwert für den Nullstrom $\Delta i^{(k)}$ (n) jedes zu überwachenden Abzweiges oder Leitungsabschnittes des Netzes und der Stempunkt-Verlagerungsspannung $\Delta u(n)$ gebildet wird und diese Differenzwerte in digitaler Form in elektronischen Speichern abgelegt werden.

6. Verfahren nach Anspruch 5, **dadurch gekennzeichnet, dass** die Absolutbeträge der Momentanwerte der Differenzwerte $\Delta i^{(k)}(n)$ jedes zu überwachenden Abzweiges oder Leitungsabschnittes und $\Delta u(n)$ mit vordefinierten Triggerschwellen verglichen werden und ein Fehlerzustand im Netz erkannt wird, wenn durch einen oder mehreren der Absolutbeträge der Differenzwerte die zugehörige Triggerschwelle hintereinanderfolgend für eine vordefinierte Anzahl überschritten wird und/oder die Absolutbeträge der Momentanwerte der Sternpunkt-Verlagerungsspannung $U_{ne}(n)$ eine vordefinierte Triggerschwelle hintereinanderfolgend für eine vordefinierte Anzahl überschreiten und dass dieser Fehlereintritt an einer Ausgabeeinheit, beispielsweise ein Ausgabekontakt oder ein elektronisches Display, angezeigt wird.

7. Verfahren nach Anspruch 5 oder 6, **dadurch gekennzeichnet, dass aus den** gespeicherten Differenzwerten $\Delta i^{(k)}$ $(n)$ und $\Delta u(n)$ mit Hilfe einer beliebigen numerischen Integrationsmethode, beispielsweise der Trapezregel, der Simpsonregel, oder einem numerischen Integrationsverfahren höherer Ordnung, die Wertefolgen $S_i(n)$, $S_1(n)$, $S_2$ $(n)$ und $S_3(n)$, bis gegebenenfalls $S_m(n)$, wobei der Index n den Wert der jeweiligen Wertefolge zum Zeitpunkt $nT$ und der Index 0 den Zeitpunkt des Fehlereintrittes bezeichnet, der Funktionen $S_i(t)$, $S_1(t)$, $S_2(t)$ und $S_3(t)$ entsprechend den Beziehungen

$$S_i(t) = \int_0^t \Delta i(\tau)\,d\tau$$

$$S_1(t) = \int_0^t \Delta u(\tau)\,d\tau$$

$$S_2(t) = \Delta u(t)$$

$$S_3(t) = \int_0^t \left( \int_0^\sigma \Delta u(\tau)\,d\tau \right) d\sigma$$

ermittelt und gespeichert werden.

8. Verfahren nach einem der Ansprüche 2 bis 7, **dadurch gekennzeichnet, dass die** Koeffizienten $a_1$, $a_2$ und $a_3$, bis gegebenenfalls $a_m$, durch eine beliebige Methode, vorzugsweise durch eine Methode im Zeitbereich, oder im Bildbereich einer beliebigen Transformation, beispielsweise der Z-Transformation, so bestimmt werden, dass die Differentialgleichung oder Differenzengleichung , bzw. die dazu äquivalente Gleichung in integraler Form, für den funktionellen Zusammenhang von Nullstrom $i^{(k)}$ eines überwachten Abzweiges oder Leitungsabschnittes $k$ und der Sternpunkt-Verlagerungsspannung $U_{ne}$ für eine vorgegebene Anzahl von Samples bestmöglich erfüllt wird **und dass** die Werte der ermittelten Koeffizienten $a_1$, $a_2$ und $a_3$, bis gegebenenfalls $a_m$, als Fehlererkennungskriterien für den entsprechenden überwachten Abzweig oder Leitungsabschnitt herangezogen werden.

9. Verfahren nach Anspruch 7, **dadurch gekennzeichnet, dass** für zumindest einen zu überwachenden Abzweig oder Leitungsabschnitt des Netzes die Koeffizienten $a_1$, $a_2$ und $a_3$ aus einem linearen Gleichungssystem dritter Ordnung,

$$\underline{\underline{C}} \cdot \underline{a} = \underline{b},$$

mit einem aus den drei Koeffizienten $a_1$, $a_2$ und $a_3$ bestehenden Lösungsvektor $\underline{a}$, einer 3x3 Matrix $\underline{\underline{C}}$ und einem dreidimensionalen Vektor $\underline{b}$, deren Elemente aus den berechneten und gespeicherten Wertefolgen $S_i(n)$, $S_1(n)$, $S_2(n)$ und $S_3(n)$ durch folgende Beziehungen ermittelt werden,

$$c_{kj} = \sum_{n=1}^{N} S_k(n) \cdot S_j(n) \qquad \forall\, k, j \in \{1,2,3\}$$

und

$$b_k = \sum_{n=1}^{N} S_i(n) \cdot S_k(n) \qquad \forall\, k \in \{1,2,3\},$$

berechnet werden **und dass** die Werte der so ermittelten Koeffizienten $a_1$, $a_2$ und $a_3$ als Fehlererkennungskriterien für den entsprechenden überwachten Abzweig oder Leitungsabschnitt herangezogen werden.

10. Verfahren nach Anspruch 8 oder 9, **dadurch gekennzeichnet, dass** ein überwachter Leitungsabschnitt oder Abzweig als fehlerhaft erkannt wird, wenn die zugehörigen Koeffizienten $a_1$ und/oder $a_2$ negativ oder kleiner einer vordefinierten Schwelle sind und als fehlerfrei erkannt wird, wenn die zugehörigen Koeffizienten $a_1$ und/oder $a_2$ positiv oder größer einer vordefinierten Schwelle sind **und dass** $a_3$ in einem stempunktisolierten Netz null wird.

11. Verfahren nach Anspruch 10, **dadurch gekennzeichnet, dass** der detektierte Fehlerzustand als ein Zuschalten oder Wegschalten dieses Abzweiges oder Leitungsabschnittes des Netzes erkannt wird, wenn alle Messwerte $U_{ne}$ und $i_0^{(k)}$ dieses Abzweiges oder Leitungsabschnittes $k$ vor beziehungsweise nach dem Zeitpunkt der Schalthandlung im Wesentlichen Null sind **und dass** in diesem Fall kein Fehlerzustand angezeigt wird.

12. Verfahren nach einem der Ansprüche 5 bis 11, **dadurch gekennzeichnet, dass** der Differenzwert für den Nullstrom $\Delta i^{(k)}(n)$ jedes zu überwachenden Abzweiges und Leitungsabschnittes des Netzes und/oder der Differenzwert für die Sternpunkt-Verlagerungsspannung $\Delta u(n)$ gleich der momentanen Messwerte der Nullströme $i_0^{(k)}$ bzw. der Stempunkt-Verlagerungsspannung $U_{ne}$ zum Zeitpunkt $nT$ gesetzt wird.

$$\Delta i^{(k)}(n) := \left[i_0^{(k)}(n)\right]$$
$$\Delta u(n) := \left[U_{ne}(n)\right] \qquad \text{mit } n \in \{0,1,2,\ldots,N\}$$

13. Verfahren nach einem der Ansprüche 1 bis 12, **dadurch gekennzeichnet, dass** das Ende des Fehlerzustandes im Netz erkannt wird, wenn der Effektivwert oder Absolutbetrag der Stempunkt-Verlagerungsspannung $U_{ne}$ eine vordefinierte Fehlerfrei-Schwelle für eine vorgegebene Zeit unterschreitet.

14. Verfahren nach einem der Ansprüche 1 bis 13, **dadurch gekennzeichnet, dass die** digitalisierten Messwerte der Sternpunkt-Verlagerungsspannung $U_{ne}$ und der Nullströme $i_0^{(k)}$ sequentiell in je einen, vorzugsweise ringförmig organisierten, elektronischen Speicher der Länge M abgelegt werden.

15. Verfahren nach Anspruch 14, **dadurch gekennzeichnet, dass** die Länge M des ringförmigen Speichers so gewählt wird, dass sie einem ganzzahligen Vielfachen des Quotienten aus Abtastfrequenz $f_A$ und Netzfrequenz $f_N$ entspricht.

16. Verfahren nach Anspruch 14 oder 15, **dadurch gekennzeichnet, dass** die berechneten Differenzwerte $\Delta i^{(k)}(n)$ und $\Delta u(n)$ sequentiell in, vorzugsweise ringförmig organisierten, elektronischen Speichern der Länge N abgelegt werden und die Länge N kleiner oder gleich als die Länge M gewählt wird.

17. Verfahren nach Anspruch 16, **dadurch gekennzeichnet, dass** nach dem Erkennen eines Fehlerzustandes noch genau N Differenzwerte $\Delta i^{(k)}(n)$ und $\Delta u(n)$ der Sternpunkt-Verlagerungsspannung $U_{ne}$ und der Nullströme $i_0^{(k)}$ gebildet und abgespeichert werden.

18. Verfahren nach Anspruch 16, **dadurch gekennzeichnet, dass** nach dem Erkennen eines Fehlerzustandes noch genau N Differenzwerte $\Delta i^{(k)}(n)$ und $\Delta u(n)$ der Stempunkt-Verlagerungsspannung $U_{ne}$ und des Nullstromes $i_0^{(k)}$ gebildet und abgespeichert werden und danach die Messwerterfassung und die Differenzwertbildung bis zur Er-

kennung des Endes des Fehlzustandes unterbrochen wird **und dass** das Verfahren nach dem Erkennen des Endes des Fehlzustandes wieder fortgesetzt wird.

**19.** Vorrichtung zur Ortung von einpoligen Erdfehlem in einem Abzweig oder einem Leitungsabschnitt eines stempunktkompensierten oder sternpunktisolierten elektrischen Versorgungsnetzes, bestehend aus einer Spannungsmesseinheit zum kontinuierlichen Messen der Sternpunkt-Verlagerungsspannung $U_{ne}$, beziehungsweise einer der Stempunkt-Verlagerungsspannung $U_{ne}$ proportionalen Messgröße, sowie für jeden zu überwachenden Abzweig oder Leitungsabschnitt $k$ des Netzes einer Strommesseinheit zum kontinuierlichen Messen des jeweiligen Nullstromes $i_0^{(k)}$, beziehungsweise einer dem Nullstrom $i_0^{(k)}$ proportionalen Messgröße, **dadurch gekennzeichnet, dass** zumindest ein Analog/Digital-Wandler vorgesehen ist, der die Messwerte zu bestimmten Zeitpunkten in eine digitale Form umwandelt, **dass** zumindest ein elektronischer Speicher zum Speichern der digitalisierten Messwerte vorgesehen ist **und dass** eine Auswerteeinheit vorgesehen ist, die zum Ausführen eines geeigneten mathematischen Verfahrens zur Ortung von einpoligen Erdfehlem anhand von Messwerten von zumindest einer Messung vor und zumindest einer Messung nach einem Fehlereintritt geeignet ist.

**20.** Vorrichtung nach Anspruch 19, **dadurch gekennzeichnet, dass** in der Auswerteeinheit für jeden zu überwachenden Abzweig oder Leitungsabschnitt $k$ des Netzes die Koeffizienten $a_1$, $a_2$ und $a_3$, bis gegebenenfalls $a_m$, einer linearen Differentialgleichung oder Differenzengleichung zweiter oder höherer Ordnung für den funktionellen Zusammenhang zwischen Nullstrom $i_0^{(k)}$ dieses Abzweiges oder Leitungsabschnittes und der Sternpunkt-Verlagerungsspannung $U_{ne}$, beziehungsweise aus deren äquivalenten Gleichung in integraler Form, vorzugsweise in numerischer Schreibweise,

$$S_i(n) = a_1 S_1(n) + a_2 S_2(n) + a_3 S_3(n)[+...+a_m S_m(n)]$$

durch eine beliebige Methode, vorzugsweise eine numerische Methode, im Zeitbereich oder im Bildbereich einer beliebigen Transformation, beispielsweise der Z-Transformation, berechenbar sind **und dass** mit diesen Koeffizienten der fehlerhafte Abzweig oder Leitungsabschnitt des Netzes bestimmbar ist.

**21.** Vorrichtung nach Anspruch 19 oder 20, **dadurch gekennzeichnet, dass** die Spannungs- und Strommesseinheiten zur Durchführung von Messungen zu äquidistanten Zeitpunkten $T$, mit einer vorgebbaren Abtastfrequenz $f_A$ und $T = \frac{1}{f_A}$, vorgesehen sind.

**22.** Vorrichtung nach Anspruch 21, **dadurch gekennzeichnet, dass** in den Spannungsund Strommesseinheiten als Abtastfrequenz $f_A$ ein ganzzahliges Vielfaches der Netzfrequenz $f_N$ wählbar ist.

**23.** Vorrichtung nach Anspruch 21 oder 22, **dadurch gekennzeichnet, dass** in der Auswerteeinheit aus den momentanen Messwerten, zum Zeitpunkt $nT$, und den entsprechenden gespeicherten Messwerten einer ganzzahligen Anzahl $j$ vorhergehender Netzperioden der Sternpunkt-Verlagerungsspannung $U_{ne}$ und der Nullströme $i_0^{(k)}$ nach den Beziehungen

$$\Delta i^{(k)}(n) := \left[ i_0^{(k)}(n) - i_0^{(k)}(n-m) \right]$$
$$\Delta u(n) := \left[ U_{ne}(n) - U_{ne}(n-m) \right]$$

$$\text{mit } n \in \{0,1,2,\ldots,N\} \text{ und } m = j \cdot \left| \frac{f_A}{f_N} \right|,$$

Differenzwerte für die Nullströme $\Delta i^{(k)}(n)$ jedes zu überwachenden Abzweiges oder Leitungsabschnittes des Netzes und die Sternpunkt-Verlagerungsspannung $\Delta u(n)$ berechenbar sind **und dass** diese Differenzwerte in digitaler Form in zumindest einem elektronischen Speichern abspeicherbar sind.

**24.** Vorrichtung nach Anspruch 23, **dadurch gekennzeichnet, dass** mittels der Auswerteeinheit ein Fehlerzustand des Netzes erkennbar und an einer Anzeigeeinheit, beispielsweise ein Ausgabekontakt oder ein elektronisches Display, anzeigbar ist, wenn die Absolutbeträge der Momentanwerte der Differenzwerte $\Delta i^{(k)}(n)$ und $\Delta u(n)$ vordefinierte Triggerschwellen hintereinanderfolgend für eine vordefinierte Anzahl überschreiten und/oder zusätzlich die Absolutbeträge der Momentanwerte der Sternpunkt-Verlagerungsspannung $U_{ne}(n)$ eine vordefinierte Triggerschwelle hintereinanderfolgend für eine vordefinierte Anzahl überschreiten.

**25.** Vorrichtung nach Anspruch 23 oder 24, **dadurch gekennzeichnet, dass** in der Auswerteeinheit aus den gespei-

cherten Differenzwerten $\Delta i^{(k)}(n)$ und $\Delta u(n)$ mit Hilfe einer beliebigen numerischen Integrationsmethode, beispielsweise der Trapezregel, der Simpsonregel, oder einem numerischen Integrationsverfahren höherer Ordnung, die Wertefolgen $S_i(n)$, $S_1(n)$, $S_2(n)$ und $S_3(n)$, bis gegebenenfalls $S_m(n)$, wobei der Index n den Wert der jeweiligen Wertefolge zum Zeitpunkt $nT$ und der Index 0 den Zeitpunkt des Fehlereintrittes bezeichnet, der Funktionen $S_i(t)$, $S_1(t)$, $S_2(t)$ und $S_3(t)$ entsprechend den Beziehungen

$$S_i(t) = \int_0^t \Delta i(\tau)d\tau$$

$$S_1(t) = \int_0^t \Delta u(\tau)d\tau$$

$$S_2(t) = \Delta u(t)$$

$$S_3(t) = \int_0^t \left( \int_0^\sigma \Delta u(\tau)d\tau \right) d\sigma$$

berechenbar und speicherbar sind.

26. Vorrichtung nach Anspruch 25, **dadurch gekennzeichnet, dass** in der Auswerteeinheit für zumindest einen zu überwachenden Abzweig oder Leitungsabschnitt des Netzes die Koeffizienten $a_1$, $a_2$ und $a_3$ aus einem linearen Gleichungssystem dritter Ordnung,

$$\underline{\underline{C}} \cdot \underline{a} = \underline{b},$$

mit einem aus den drei Koeffizienten $a_1$, $a_2$ und $a_3$ bestehenden Lösungsvektor $\underline{a}$, einer 3x3 Matrix $\underline{C}$ und einem dreidimensionalen Vektor $\underline{b}$, deren Elemente aus den gespeicherten Wertefolgen $S_i(n)$, $S_1(n)$, $S_2(n)$ und $S_3(n)$ durch folgende Beziehungen ermittelbar sind,

$$c_{kj} = \sum_{n=1}^{N} S_k(n) \cdot S_j(n) \qquad \forall\, k, j \in \{1,2,3\}$$

und

$$b_k = \sum_{n=1}^{N} S_i(n) \cdot S_k(n) \qquad \forall\, k \in \{1,2,3\},$$

berechenbar sind **und dass** mit diesen Koeffizienten der fehlerhafte Abzweig oder Leitungsabschnitt des Netzes bestimmbar ist.

27. Vorrichtung nach Anspruch 20 oder 26, **dadurch gekennzeichnet, dass** in der Auswerteeinheit ein Abzweig oder Leitungsabschnitt des Netzes als fehlerhaft erkennbar ist, wenn die zugehörigen Koeffizienten $a_1$ und/oder $a_2$ negativ oder kleiner einer vorgegebenen Schwelle sind und als fehlerfrei erkennbar sind, wenn die zugehörigen Koeffizienten $a_1$ und/oder $a_2$ positiv oder größer einer vorgegebenen Schwelle sind.

28. Vorrichtung nach Anspruch 27, **dadurch gekennzeichnet, dass** in der Auswerteeinheit ein Zuschalten oder Wegschalten eines Abzweiges oder Leitungsabschnittes des Netzes erkennbar ist, wenn alle Messwerte $U_{ne}$ und $i_0^{(k)}$

dieses Abzweiges oder Leitungsabschnittes vor beziehungsweise nach dem Zeitpunkt der Schalthandlung im Wesentlichen Null sind.

29. Vorrichtung nach einem der Ansprüche 23 bis 28, **dadurch gekennzeichnet, dass** der Differenzwert für den Nullstrom $\Delta i^{(k)}(n)$ jedes zu überwachenden Abzweiges oder Leitungsabschnittes des Netzes und/oder der Differenzwert für die Sternpunkt-Verlagerungsspannung $\Delta u(n)$ gleich der momentanen Messwerte der Nullströme $i_0^{(k)}$ bzw. der Sternpunkt-Verlagerungsspannung $U_{ne}$ zum Zeitpunkt $nT$ ist.

$$\Delta i^{(k)}(n) := \left[i_0^{(k)}(n)\right]$$
$$\Delta u(n) := \left[U_{ne}(n)\right] \qquad \text{mit } n \in \{0,1,2,\ldots,N\}$$

30. Vorrichtung nach einem der Ansprüche 19 bis 29, **dadurch gekennzeichnet, dass** in der Auswerteeinheit das Ende des Fehlerzustandes erkennbar ist, wenn der Effektivwert oder der Absolutbetrag der Sternpunkt-Verlagerungsspannung $U_{ne}$ eine vordefinierte Fehlerfrei-Schwelle unterschreitet.

31. Vorrichtung nach einem der Ansprüche 19 bis 30, **dadurch gekennzeichnet, dass** für zumindest eine zu messende Größe ein, vorzugsweise ringförmig organisierter, elektronischer Speicher der Länge M zum sequentiellen Speichern der digitalisierten Messwerte vorgesehen ist **und dass** als Länge M der Speicher ein ganzzahliges Vielfaches des Quotienten aus Abtastfrequenz $f_A$ und Netzfrequenz $f_N$ wählbar ist.

32. Vorrichtung nach einem der Ansprüche 23 bis 31, **dadurch gekennzeichnet, dass** für die Differenzwerte zumindest einer zu messenden Größe ein, vorzugsweise ringförmig organisierter, elektronischer Speicher der Länge N zum sequentiellen Speichern der Differenzwerte vorgesehen ist.

33. Vorrichtung nach einem der Ansprüche 19 bis 32, **dadurch gekennzeichnet, dass** die Auswerteeinheit ein Mikroprozessor ist.

## Claims

1. A method for localising single-pole earth faults in a branch or line section of a compensated neutral point or isolated neutral point electrical supply network, in which the neutral point displacement voltage $U_{ne}$, or a measured quantity proportional to the neutral point displacement voltage $U_{ne}$, and a zero current $i_0^{(k)}$ or a measured quantity proportional to the zero current $i_0^{(k)}$, of each branch or line section $k$ of the network to be monitored are measured in a suitable manner **characterised in that** the measured values of the neutral point displacement voltage $U_{ne}$ and the zero currents $i_0^{(k)}$ are digitised at predetermined times and the measured values are stored in digital form in at least one electronic memory **and that** the stored measured values of at least one measurement before and at least one measurement after a fault occurrence are evaluated with a suitable mathematical method for localising single-pole earth faults.

2. A method according to claim 1, **characterised in that** the functional connection of the behaviour of the branch or line section zero current $i_0^{(k)}$ of each branch or line section $k$ of the network to be monitored, and of the neutral point displacement voltage $U_{ne}$ both for the case where no fault is present and also for the case where a fault has occurred is described by a second or higher-order linear differential equation or difference equation, or by the associated equivalent equation of this in integral form, preferably in the numerical notation

$$S_i(n) = a_1 S_1(n) + a_2 S_2(n) + a_3 S_3(n) [+\ldots+a_m S_m(n)]$$

**and that** the case where a fault has occurred differs from the case where no fault is present only by coefficients $a_1$, $a_2$ and $a_3$, up to $a_m$ if required.

3. A method according to claim 1 or 2, **characterised in that** the neutral point displacement voltage $U_{ne}$ and the zero currents $i_0^{(k)}$ are measured at equidistant times $T$, corresponding to a predefined sampling frequency $f_A$, with $T = \frac{1}{f_A}$.

4. A method according to claim 3, **characterised in that the** sampling frequency $f_A$ is chosen in such a way that it corresponds to an integral multiple of the network frequency $f_N$.

5. A method according to claim 3 or 4, **characterised in that** continuously from the instantaneous measured values, at time $nT$, and the corresponding stored measured values of an integral number $j$ of preceding network periods, of the neutral point displacement voltage $U_{ne}$ and the zero currents $i_0^{(k)}$ according to the relations

$$\Delta i^{(k)}(n) := \left[ i_0^{(k)}(n) - i_0^{(k)}(n-m) \right]$$
$$\Delta u(n) := \left[ U_{ne}(n) - U_{ne}(n-m) \right] \qquad \text{with} \qquad n \in \{0,1,2,...,N\} \text{ und } m = j \cdot \left| \frac{f_A}{f_N} \right|,$$

in each case a difference value is formed for the zero current $\Delta_i^{(k)}(n)$ of each branch or line section of the network to be monitored and of the neutral point displacement voltage $\Delta u(n)$ and these different values are stored in digital form in electronic memories.

6. A method according to claim 5, **characterised in that** the absolute magnitudes of the instantaneous values of the difference values $\Delta_i^{(k)}(n)$ of each branch or line section to be monitored and $\Delta u(n)$ are compared with predefined tripping thresholds and a fault condition in the network is detected if the associated tripping threshold is exceeded consecutively for a predefined count by one or more of the absolute magnitudes of the difference values and/or the absolute magnitudes of the instantaneous values of the neutral point displacement voltage $U_{ne}(n)$ exceed a predefined tripping threshold consecutively for a predefined count **and that** this fault occurrence is displayed on an output unit, for example an output contact or an electronic display.

7. A method according to claim 5 or 6, **characterised in that** from the stored difference values $\Delta_i^{(k)}(n)$ and $\Delta u(n)$ by means of any desired numerical method of integration, for example the trapezoidal rule, Simpson's rule, or a higher-order numerical integration method, the value series $S_i(n)$ , $S_1(n)$, $S_2(n)$ and, $S_3(n)$ up to $S_m(n)$ if required, the index n designating the value of the value series at time $nT$ and the index 0 the time of the fault occurrence, the functions $S_i(t)$, $S_1(t)$, $S_2(t)$ and $S_3(n)$ are determined according to the relations

$$S_i(t) = \int_0^t \Delta i(\tau)\, d\tau$$

$$S_1(t) = \int_0^t \Delta u(\tau)\, d\tau$$

$$S_2(t) = \Delta u(t)$$

$$S_3(t) = \int_0^t \left( \int_0^\sigma \Delta u(\tau)\, d\tau \right) d\sigma$$

and stored.

8. A method according to any one of claims 2 to 7, **characterised in that** the coefficients $a_1$, $a_2$ and $a_3$, up to $a_m$ if required are determined by any desired method, preferably by a method in the time domain, or in the image domain of any desired transformation, for example z-transformation, in such a way that the differential equation or difference equation, or the equation in integral form equivalent to this, for the functional connection of the zero current $i_0^{(k)}$ of a monitored branch or line section $k$ and the neutral point displacement voltage $U_{ne}$ is fulfilled as well as possible for a prescribed number of samples **and that** the values of the determined coefficients $a_1$, $a_2$ and $a_3$ , up to $a_m$ if required are utilised as error detection criteria for the appropriate monitored branch or line section.

9. A method according to claim 7, **characterised in that** for at least one branch or line section of the network to be monitored, the coefficients $a_1$, $a_2$ and $a_3$ are calculated from a third-order linear equation system

$$\underline{\underline{C}} \cdot \underline{a} = \underline{b},$$

with a solution vector $\underline{a}$ consisting of the three coefficients $a_1$, $a_2$ and $a_3$, a 3x3 matrix $\underline{\underline{C}}$ and a three-dimensional vector $\underline{b}$, the elements of which are determined from the calculated and stored series of values $S_i(n)$, $S_1(n)$, $S_2(n)$ and $S_3(n)$ from the following relations

$$c_{kj} = \sum_{n=1}^{N} S_k(n) \cdot S_j(n) \qquad \forall\, k, j \in \{1,2,3\}$$

and

$$b_k = \sum_{n=1}^{N} S_i(n) \cdot S_k(n) \qquad \cdot\, \forall\, k \in \{1,2,3\},$$

**and that** the values of the coefficients $a_1$, $a_2$ and $a_3$ determined in this way are utilised as fault detection criteria for the corresponding monitored branch or line section.

10. A method according to claim 8 or 9 **characterised in that** a monitored line section or branch is detected as faulty if the associated coefficients $a_1$ and/or $a_2$ are negative or smaller than a predefined threshold and is detected as fault-free if the associated coefficients $a_1$ and/or $a_2$ are positive or greater than a predefined threshold **and that** $a_3$ is zero in an isolated neutral point network.

11. A method according to claim 10, **characterised in that** the identified fault condition is detected as the bringing into or taking out of circuit of this branch or line section of the network, if all measured values $U_{ne}$ and $i_0^{(k)}$ of this branch or line section $k$ are substantially zero before or after the time of the switching operations **and that** in this case no fault condition is displayed.

12. A method according to any one of claims 5 to 11, **characterised in that** the difference value for the zero current $\Delta_i^{(k)}(n)$ of each branch and line section of the network to be monitored and/or the difference value for the neutral point displacement voltage $\Delta u(n)$ is taken as equal to the instantaneous measured values of the zero currents $i_0^{(k)}$ or of the neutral point displacement voltage $U_{ne}$ at time $nT$.

$$\Delta i^{(k)}(n) := \left[ i_0^{(k)}(n) \right]$$
$$\Delta u(n) := \left[ U_{ne}(n) \right] \qquad \text{with}\ : n \in \{0,1,2,...,N\}$$

13. A method according to any one of claims 1 to 12, **characterised in that** the end of the fault condition in the network is detected when the rms value or absolute magnitude of the neutral point displacement voltage $U_{ne}$ falls below a predefined fault-free threshold for a prescribed time.

14. A method according to any one of claims 1 to 13, **characterised in that** the digitised measured values of the neutral point displacement voltage $U_{ne}$ and of the zero currents $i_0^{(k)}$ are stored sequentially each in an electronic memory, preferably organised in ring form, of length M.

15. A method according to claim 14, **characterised in that** the length M of the memory in ring form is chosen in such a way that it corresponds to an integral multiple of the quotient of the sampling frequency $f_A$ and network frequency $f_N$.

16. A method according to claim 14 or 15, **characterised in that** the calculated difference values $\Delta_i^{(k)}(n)$ and $\Delta u(n)$ are stored sequentially in electronic memories, preferably organised in ring form, of length N and the length N is chosen as smaller than or equal to the length M.

17. A method according to claim 16, **characterised in that** after the detection of a fault condition precisely N more difference values $\Delta_i^{(k)}(n)$ and $\Delta u(n)$ of the neutral point displacement voltage $U_{ne}$ and of the zero currents $i_0^{(k)}$ are formed and stored.

18. A method according to claim 16, **characterised in that** after the detection of a fault condition precisely N more difference values $\Delta_i^{(k)}(n)$ and $\Delta u(n)$ of the neutral point displacement voltage $U_{ne}$ and of the zero current $i_0^{(k)}$ are formed and stored and thereafter measured value acquisition and difference value formation is interrupted until the end of the fault condition is detected **and that** it is continued again after detection of the end of the fault condition.

19. A device for localising single-pole earth faults in a branch or a line section of a compensated neutral point or isolated neutral point electrical supply network, consisting of a voltage measurement unit for continuous measurement of the neutral point displacement voltage $U_{ne}$, or of a measured quantity proportional to the neutral point displacement voltage $U_{ne}$ , and also for each branch or line section $k$ of the network to be monitored a current measurement unit for continuous measurement of the zero current $i_0^{(k)}$ or a measured quantity proportional to the zero current $i_0^{(k)}$, **characterised in that** at least one analogue/digital converter is provided which converts the measured values at specific times into digital form, **that** at least one electronic memory for storing the digitised measured values is provided **and that** an evaluation unit is provided which is suitable for carrying out a suitable mathematical method for localising single-pole earth faults on the basis of measured values of at least one measurement before and at least one measurement after the occurrence of a fault.

20. A device according to claim 19, **characterised in that** in the evaluation unit for each branch or line section k of the network to be monitored, the coefficients $a_1$, $a_2$ and $a_3$ , up to $a_m$ if required, of a second or higher-order linear differential equation or difference equation for the functional connection between the zero current $i_0^{(k)}$ of this branch or line section and the neutral point displacement voltage $U_{ne}$, or from the equation equivalent to this in integral form, preferably in numerical notation,

$$S_i(n) = a_1 S_1(n) + a_2 S_2(n) + a_3 S_3(n) [+...+a_m S_m(n)]$$

can be calculated by any desired method, preferably a numerical method, in the time domain or in the image domain of any desired transformation, for example z-transformation, **and that** with these coefficients the faulty branch or line section of the network can be determined.

21. A device according to claim 19 or 20, **characterised in that** the voltage and current measuring units are provided for carrying out measurements at equidistant times $T$, with a prescribable sampling frequency $f_A$ and $T = \frac{1}{f_A}$.

22. A device according to claim 21, **characterised in that** in the voltage and current measuring units an integral multiple of the network frequency $f_N$ can be selected as the sampling frequency $f_A$.

23. A device according to claim 21 or 22, **characterised in that** in the evaluation unit from the instantaneous measured values, at time $nT$, and the corresponding stored measured values of an integral number $j$ of preceding network periods of the neutral point displacement voltage $U_{ne}$ and of the zero currents $i_0^{(k)}$, difference values for the zero currents $\Delta i^{(k)}(n)$ of each branch or line section of the network to be monitored and the neutral point displacement voltage $\Delta u(n)$ can be calculated according to the relations

$$\Delta i^{(k)}(n) = \left[ i_0^{(k)}(n) - i_0^{(k)}(n-m) \right]$$
$$\Delta u(n) = \left[ U_{ne}(n) - U_{ne}(n-m) \right]$$

$$\text{with} \quad : n \in \{0,1,2,...,N\} \text{ und } m = j \cdot \left| \frac{f_A}{f_N} \right|.$$

**and that** these difference values can be stored in digital form in the least one electronic memory.

24. A device according to claim 23, **characterised in that** by means of the evaluation unit a fault condition of the network can be detected and can be displayed on a display unit, for example an output contact or an electronic display, when the absolute magnitudes of the instantaneous values of the difference values $\Delta i^{(k)}$ *(n)* and $\Delta u(n)$ exceed predefined tripping thresholds consecutively for a predefined count and/or in addition the absolute magnitudes of the instantaneous values of the neutral point displacement voltage $U_{ne}$ *(n)* exceed a predefined tripping threshold consecutively for a predefined count.

25. A device according to claim 23 or 24, **characterised in that** in the evaluation unit from the stored difference values $\Delta i^{(k)}(n)$ and $\Delta u(n)$ by means of any desired numerical integration method, for example the trapezoidal rule, Simpson's rule, or a higher-order numerical integration method, the series of values $S_i(n)$, $S_1(n)$, $S_2(n)$ and $S_3(n)$ up to $S_m(n)$ if required, the index n designating the value of the series of values in each case at time $nT$ and the index 0 the time of the fault occurrence, of the functions $S_i(t)$, $S_1(t)$, $S_2(t)$ and $S_3(t)$ can be calculated according to the relations

$$S_i(t) = \int_0^t \Delta i(\tau)\,d\tau$$

$$S_1(t) = \int_0^t \Delta u(\tau)\,d\tau$$

$$S_2(t) = \Delta u(t)$$

$$S_3(t) = \int_0^t \left( \int_0^\sigma \Delta u(\tau)\,d\tau \right) d\sigma$$

and stored.

26. A device according to claim 25, **characterised in that** in the evaluation unit for at least one branch or line section of the network to be monitored the coefficients $a_1$, $a_2$ and $a_3$ from a third-order linear equation system

$$\underline{\underline{C}} \cdot \underline{a} = \underline{b},$$

with a solution vector $\underline{a}$ consisting of the three coefficients $a_1$, $a_2$ and $a_3$, a 3x3 matrix $\underline{\underline{C}}$ and a three-dimensional vector $\underline{b}$, the elements of which can be determined from the stored series of values $S_i(n)$, $S_1(n)$, $S_2(n)$ and $S_3(n)$ by the following relations

$$c_{kj} = \sum_{n=1}^{N} S_k(n) \cdot S_j(n) \qquad \forall\, k, j \in \{1,2,3\}$$

and

$$b_k = \sum_{n=1}^{N} S_i(n) \cdot S_k(n) \qquad \forall\, k \in \{1,2,3\},$$

can be calculated, **and that** with these coefficients the faulty branch or line section of the network can be determined.

27. A device according to claim 20 or 26, **characterised in that** in the evaluation unit a branch or line section of the network can be detected as faulty if the associated coefficients $a_1$ and/or $a_2$ are negative or smaller than a prescribed threshold and detected as fault-free if the associated coefficients $a_1$ and/or $a_2$ are positive or greater than a prescribed threshold.

28. A device according to claim 27, **characterised in that** in the evaluation unit, the bringing into or taking out of circuit of a branch or line section of the network can be detected if all measured values $U_{ne}$ and $i_0^{(k)}$ of this branch or line section are substantially zero before and after the time of the switching operation.

29. A device according to any one of claims 23 to 28, **characterised in that** the difference value for the zero current $\Delta i^{(k)}(n)$ of each branch or line section of the network to be monitored and/or the difference value for the neutral point displacement voltage $\Delta u(n)$ is equal to the instantaneous measured values of the zero currents $i_0^{(k)}$ or of the neutral point displacement voltage $U_{ne}$ at time nT.

$$\Delta i^{(k)}(n) := \left[ i_0^{(k)}(n) \right]$$
$$\Delta u(n) := \left[ U_{ne}(n) \right] \qquad \text{with } n \in \{0,1,2,\ldots,N\}$$

30. A device according to any one of claims 19 to 29, **characterised in that** in the evaluation unit the end of the fault condition can be detected when the rms value or the absolute magnitude of the neutral point displacement voltage $U_{ne}$ falls below a predefined fault-free threshold.

31. A device according to any one of claims 19 to 30, **characterised in that** for at least one quantity to be measured, an electronic memory of length M, preferably organised in ring form, is provided for sequential storage of the digitised measured values **and that** as the length M of the memories an integral multiple of the quotient of the sampling frequency $f_A$ and network frequency $f_N$ can be chosen.

32. A device according to any one of claims 23 to 31, **characterised in that** for the difference values of at least one quantity to be measured, an electronic memory of length N, preferably organised in ring form, is provided for sequential storage of the difference values.

33. A device according to any one of claims 19 to 32, **characterised in that** the evaluation unit is a microprocessor.

**Revendications**

1. Procédé pour localiser des défauts à la terre monopolaires, dans une ramification ou un tronçon de ligne d'un réseau d'alimentation électrique à point neutre compensé ou à point neutre isolé, pour lequel une tension de décalage de point neutre $U_{nt}$, respectivement une grandeur de mesure proportionnelle à la tension d'alimentation de point neutre $U_{ns}$ et un courant homopolaire $i_o^{(k)}$ respectivement une grandeur de mesure proportionnelle au courant homopolaire $i_o^{(k)}$ de chaque ramification ou tronçon de ligne k à surveiller du réseau est mesuré(e) de manière appropriée, **caractérisé en ce que** les valeurs de mesure de la tension de décalage de point neutre $U_{ns}$ et des courants homopolaires $i_o^{(k)}$ sont numérisés à des moments prédéterminés, et les valeurs de mesure sont déposées sous forme numérique en au moins une mémoire électronique, et **en ce que** les valeurs de mesure mémorisées d'au moins une mesure sont évaluées, avant, et au moins une mesure, après l'apparition des défauts, avec un procédé mathématique approprié, servant à localiser des défauts de terre monopolaire.

**2.** Procédé selon la revendication 1, **caractérisé en ce que** la liaison fonctionnelle, du comportement du courant homopolaire de ramification ou de tronçon de ligne $i_o^{(k)}$ de chaque ramification ou tronçon de ligne k à surveiller du réseau et de la tension de décalage de point neutre $U_{ns}$ ainsi que, pour le cas d'exemption d'erreur, ainsi qu'également pour le cas de défaut, est décrit par une équation différentielle linéaire ou une équation différentielle de deuxième ordre ou d'ordre supérieur, respectivement par son équation équivalente afférente sous forme intégrale, de préférence selon le mode d'écriture numérique suivant :

$$S_1(n) = a_1 S_1(n) + a_2 S_2(n) + a_3 S_3(n)[+...+a_m S_{ns}(n)],$$

et **en ce que** le cas de défaut se distingue de celui à absence de défaut uniquement par des coefficients $a_1$, $a_2$ et $a_3$, le cas échéant jusqu'à $a_m$.

**3.** Procédé selon la revendication 1 ou 2, **caractérisé en ce que** la tension de décalage de point neutre $U_{ns}$ et les courants homopolaires $i_o^{(k)}$ sont mesurés à des moments T équidistants, de manière correspondantes à une fréquence de balayage exploratoire $f_A$ prédéterminée, avec $T = \frac{1}{f_A}$.

**4.** Procédé selon la revendication 3, **caractérisé en ce** la fréquence de balayage exploratoire $f_A$ est choisie de manière qu'elle corresponde à un multiple entier de la fréquence de réseau $F_N$.

**5.** Procédé selon la revendication 3 ou 4, **caractérisé en ce que**, de façon continue à partir des valeurs de mesure momentanées, à l'instant nT et à partir des valeurs de mesure mémorisées correspondantes d'un nombre j entier de périodes de réseau précédentes, de la tension de décalage de point neutre $U_{ns}$ et des courants homopolaires $i_o^{(k)}$ selon les relations

$$\Delta i^{(k)}(n) = [i_o^{(k)}(n) - i_o^{(k)}(n-m)]$$

$$\Delta u(n) = [U_{ns}(n) - U_{ns}(n-m)]$$

avec $n \in \{0,1,2,...,N\}$ et

$$m = j \cdot \left| \frac{f_A}{f_N} \right|,$$

on forme chaque fois une valeur de différence pour le courant homopolaire $\Delta i^{(k)}(n)$ de chaque ramification ou tronçon de ligne à surveiller du réseau et de la tension de décalage de point neutre $\Delta u(n)$, et l'on dépose ces valeurs de différence sous forme numérique dans des mémoires électroniques.

**6.** Procédé selon la revendication 5, **caractérisé en ce que** les valeurs absolues des valeurs momentanées des valeurs de différence $\Delta i^{(k)}(n)$ de chaque ramification ou tronçon de ligne à surveiller et $\Delta u(n)$ sont comparés à des seuils de déclenchement prédéfinis, et un état de défaut dans le réseau est identifié lorsque, au moyen d'une ou plusieurs des valeurs absolues des valeurs de différence, le seuil de déclenchement approprié est successivement dépassé pour un nombre prédéfini et/ou les valeurs absolues des valeurs momentanées de la tension de décalage de point neutre $U_{ne}(n)$ dépassent un seuil de déclenchement prédéfini les unes à la suite des autres pour un nombre prédéfini, et **en ce que** cette apparition de défaut est affichée sur une unité d'édition, par exemple un contact d'édition, ou bien un visuel d'affichage électronique.

**7.** Procédé selon la revendication 5 ou 6, **caractérisé en ce que**, à partir des valeurs de différence $\Delta i^{(k)}(n)$ et $\Delta u(n)$, à l'aide d'une méthode d'intégration numérique quelconque, par exemple la règle de trapèze, la règle de Simpson ou bien un procédé d'intégration numérique d'ordre plus élevé, les suites de valeur $S_i(n)$, $S_1(n)$, $S_2(n)$ et $S_3(n)$, jusqu'à le cas échéant $S_m(n)$, sachant que l'index n désigne la valeur de la succession de valeurs respectives au moment nT et que l'indice 0 désigne le moment de l'apparition du défaut, des fonctions $S_i(t)$, $S_1(t)$, $S_2(t)$ et $S_3(t)$ sont déterminées et mémorisées de manière correspondante aux relations ;

$$S_i(t) = \int_0^{\tau} \Delta i(\tau)d\tau$$

$$S_1(t) = \int_0^{\tau} \Delta u(\tau)d\tau$$

$$S_2(t) = \Delta u(t)$$

$$S_3(t) = \int_0^t \left( \int_0^{\sigma} \Delta u(\tau)d\tau \right) d\sigma \; .$$

**8.** Procédé selon l'une des revendications 2 à 7, **caractérisé en ce que** les coefficients $a_1$, $a_2$, et $a_3$, jusqu'à le cas échéant $a_m$, sont déterminés par une méthode quelconque, de préférence, par une méthode dans le dommaine des temps, ou bien dans la zone image d'une transformation quelconque, par exemple, la transformation Z, de manière que l'équation différentielle ou l'équation de différences, ou l'équation leurs étant équivalente sous forme intégrale, pour la relation fonctionnelle entre le courant homopolaire $i^{(k)}_o$, d'une ramification ou d'un tronçon de ligne k surveillé, et la tension de décalage de point neutre Une, pour un nombre prédéterminé d'échantillons, soit satisfaite de la façon la meilleure possible, et que les valeurs des coefficients $a_1$, $a_2$, et $a_3$, jusqu'à, le cas échéant, $a_m$ déterminés, soient utilisées comme critères d'identification de défaut pour la ramification ou le tronçon de ligne surveillé correspondant.

**9.** Procédé selon la revendication 7, **caractérisé en ce, que** pour au moins une ramification ou un tronçon de ligne à surveiller du réseau, les coefficients $a_1$, $a_2$, et $a_3$ soient déterminés à partir du système d'équation linéaire de troisième ordre,

$$\underline{\underline{C}} \cdot \underline{a} = \underline{b}.$$

avec un vecteur solution a formé des trois coefficients $a_1$, $a_2$, et $a_3$, une matrice 3x3 $\underline{\underline{C}}$ et un vecteur tridimensionnelle $\underline{b}$, dont les éléments sont déterminés à partir des suites de valeurs calculées et mémorisées $S_i(n)$, $S_1(n)$, $S_2(n)$ et $S_3(n)$ par les relations suivantes,

$$c_{kj} = \sum_{n=i}^{N} S_k(n) \cdot S_j(n) \qquad \forall \; k,j \; \in \; \{1,2,3\}$$

et

$$b_k = \sum_{n=i}^{N} S_i(n) \cdot S_k(n) \qquad \forall \; k,j \; \in \; \{1,2,3\},$$

et **en ce que** les valeurs des coefficients $a_1$, $a_2$ ainsi déterminés sont utilisées comme critères d'identification de défaut pour la ramification ou le tronçon de ligne surveillé correspondant.

**10.** Procédé selon la revendication 8 ou 9, **caractérisé en ce qu'**un tronçon de ligne ou une ramification surveillé(e) est identifié(e) comme étant sujet(te) à défaut, si les coefficients $a_1$ et/ou $a_2$ afférents sont négatifs ou inférieurs à un seuil prédéfini, et est identifié comme exempt de tout défauts, si les coefficients $a_1$ et/ou $a_2$ afférents sont positifs ou supérieurs à un seuil prédéfini, et **en ce que** $a_3$ est égal à zéro dans un réseau à point neutre isolé.

**11.** Procédé selon la revendication 10, **caractérisé en ce que** l'état de défaut détecté est identifié comme branchement ou débranchement de cette ramification ou tronçon de ligne du réseau, si toutes les valeurs de mesure $U_{ne}$ et $i^{(k)}_o$ de cette ramification ou tronçon de ligne k sont sensiblement de valeur zéro, avant, respectivement après, le moment de la manipulation de commutation, et **en ce que**, dans ce cas, aucun état de défaut n'est affiché.

**12.** Procédé selon l'une des revendications 5 à 11, **caractérisé en ce que** la valeur de différence pour le courant homopolaire $\Delta i^{(k)}(n)$ de chaque ramification et tronçon de ligne à surveiller du réseau, et/ou la valeur de différence pour la tension de décalage de point neutre $\Delta u(n)$, est égale aux valeurs de mesure momentanées des courants homopolaires $i^{(k)}_o$ ou à la tension de décalage de point neutre $U_{ne}$ au moment nT.

$$\Delta i^{(k)}(n) := \left[ i^{(k)}_o(n) \right]$$

avec n = {0, 1, 2, ..., N},

$$\Delta u(n) := \left[ u_{ne}(n) \right]$$

**13.** Procédé selon l'une des revendications 1 à 12, **caractérisé en ce que** la fin de l'état de défaut dans le réseau est identifiée lorsque la valeur effective ou la valeur absolue de la tension de décalage de point neutre $U_{ne}$ dépasse un seuil d'exemption de défaut prédéfini, pour une durée prédéterminée.

**14.** Procédé selon l'une des revendications 1 à 13, **caractérisé en ce que** les valeurs de mesure numérisées de la tension de décalage de point neutre $U_{ne}$ et des courants nuls $i^{(k)}_o$ sont déposées séquentiellement chaque fois dans une mémoire électronique, de préférence organisée en anneau, de longueur M.

**15.** Procédé selon la revendication 14, **caractérisé en ce que** la longueur M de la mémoire en forme d'anneau est choisie telle qu'elle correspond à un multiple entier du quotient formé de la fréquence de balayage $f_A$ et de la fréquence de réseau $f_N$.

**16.** Procédé selon la revendication 14 ou 15, **caractérisé en ce que** les valeurs de différence calculées $\Delta i^{(k)}(n)$ et $\Delta u$ (n) sont placées séquentiellement dans des mémoires électroniques, de préférence organisées en anneau, de longueur N, et la longueur N étant choisie égale ou inférieure à la longueur M.

**17.** Procédé selon la revendication 16, **caractérisé en ce que**, après identification d'un état de défaut, encore précisément N valeurs de différence $\Delta i^{(k)}(n)$ et $\Delta u(n)$, de la tension de décalage de point neutre Une et des courants nuls $i^{(k)}_o$, sont formées et mémorisées.

**18.** Procédé selon la revendication 17, **caractérisé en ce que**, après identification d'un état de défaut, encore précisément N valeurs de différence $\Delta i^{(k)}(n)$ et $\Delta u(n)$, de la tension de décalage de point neutre $U_{ne}$ et du courant homopolaire $i^{(k)}_o$, sont formées et mémorisées et, ensuite, la détection de valeur de mesure et la formation de valeurs de différence sont interrompues jusqu'à identification de la fin d'un état de défaut, et **en ce que** le procédé est de nouveau continué après identification de la fin de l'état de défaut.

**19.** Dispositif pour localiser des défauts à la terre monopolaires dans une ramification ou un tronçon de ligne d'un réseau d'alimentation électrique à point neutre compensé ou à point neutre isolé, formé d'une unité de mesure de tension pour la mesure continue de la tension de décalage de point neutre $U_{ne}$, respectivement d'une grandeur de mesure proportionnelle à la tension de décalage de point neutre $U_{ne}$, ainsi que pour chaque ramification ou tronçon de ligne k à surveiller du réseau, d'une unité de mesure de courant pour la mesure en continu du courant homopolaire $i^{(k)}_o$ respectif, respectivement d'une grandeur de mesure proportionnelle au courant homopolaire $i^{(k)}_o$, **caractérisé en ce qu'**est prévu au moins un convertisseur analogique-numérique, convertissant les valeurs de mesure à des moments déterminés sous une forme numérique, **en ce qu'**au moins une mémoire électronique est prévue pour mémoriser les valeurs de mesure numérisées, et **en ce qu'**une unité d'évaluation est prévue, convenant pour appliquer un procédé mathématique approprié, pour localiser des défauts de terre monopolaires, à l'aide de valeurs de mesure venant d'au moins une mesure, avant, et d'au moins une mesure après, l'apparition du défaut.

**20.** Procédé selon la revendication 19, **caractérisé en ce** dans l'unité d'évaluation, pour chaque ramification ou tronçon de ligne k à surveiller du réseau, les coefficients $a_1$, $a_2$, et $a_3$ jusqu'à, le cas échéant, $a_m$, d'une équation différentielle linéaire ou d'une équation de différence linéaire, de deuxième ordre ou d'un ordre supérieur, pour la relation fonctionnelle, entre le courant homopolaire $i_o^{(k)}$ de cette ramification ou tronçon de ligne et la tension de décalage de point neutre $U_{ne}$, respectivement à partir de son équation équivalente sous forme intégrale, de préférence sous un mode d'écriture numérique,

$$S_i(n) = a_1 S_1(n) + a_2 S_2(n) + a_3 S_3(n) \ [+ \ ... \ + a_m S_m(n)],$$

sont susceptibles d'être calculés au moyen d'une méthode quelconque, de préférence une méthode numérique, dans le domaine des temps ou bien dans le domaine des images d'une transformation quelconque, par exemple la transformation, et en ce que, avec ces coefficients, on peut déterminer quelle est ramification ou le tronçon de ligne du réseau défectueux.

**21.** Dispositif selon la revendication 19 ou 20, **caractérisé en ce que** les unités de mesure de tension et d'intensité sont prévues pour effectuer des mesures à des moments T équidistants, avec une fréquence de balayage $f_A$ et $T = \dfrac{1}{f_A}$ prédéterminée.

**22.** Dispositif selon la revendication 21, **caractérisé en ce que**, dans les unités de mesure de tension et d'intensité, on peut choisir comme fréquence de balayage $f_A$ un multiple entier de la fréquence de réseau $f_N$.

**23.** Dispositif selon la revendication 21 ou 22, **caractérisé en ce que** dans l'unité d'évaluation à partir des valeurs de mesure momentanées, au moment nT, et des valeurs de mesure mémorisées correspondantes d'un nombre j entier de période de réseau précédente, de la tension de décalage de point neutre $U_{ne}$ et des courants homopolaires $i_o^{(k)}$ d'après les relations

$$\Delta i^{(k)}(n) := [i_o^{(k)}(n) - i_o^{(k)}(n-m)]$$

avec $n \in \{0,1,2, ..., N\}$ et

$$m = j \cdot \left| \frac{f_A}{f_N} \right|,$$

$$\Delta u(n) = [U_{ne}(n) - U_{ne}(n-m)],$$

on peut calculer des valeurs de différence pour les courants homopolaires $\Delta i^{(k)}(n)$ de chaque ramification ou tronçon de ligne à surveiller du réseau et la tension de décalage de point neutre $\Delta u(n)$, et **en ce que** ces valeurs de différence peuvent être mémorisées sous forme numérique en au moins une mémoire électronique.

**24.** Dispositif selon la revendication 23, **caractérisé en ce que**, à l'aide de l'unité d'évaluation, on peut identifier un état de défaut du réseau et effectuer un affichage sur une unité d'affichage, par exemple un contact de sortie ou un visuel d'affichage électronique, si les valeurs absolues des valeurs momentanées des valeurs de différence $\Delta i^{(k)}(n)$ et $\Delta u(n)$ dépassent des valeurs de seuil prédéfinies les unes derrière les autres pour un nombre de valeurs prédéfinies et/ou qu'en plus les valeurs absolues des valeurs momentanées de la tension de décalage de point neutre $U_{ne}$ dépassent une valeur de déclenchement prédéfinie les unes à la suite des autres pour un nombre prédéfini.

**25.** Dispositif selon la revendication 23 ou 24, **caractérisé en ce que**, dans l'unité d'évaluation, à partir des valeurs de différence $\Delta i^{(k)}(n)$ et $\Delta u(n)$, à l'aide d'une méthode d'intégration numérique quelconque, par exemple la règle des trapèzes, la règle de Simpson, ou un procédé d'intégration numérique, d'ordre supérieur, on peut calculer et mémoriser les suites de valeurs $S_i(n)$, $S_1(n)$, $S_2(n)$ et $S_3(n)$, jusqu'à, le cas échéant $S_m(n)$, sachant que l'index n désigne la valeur de la succession de valeurs respectives au moment nT et que l'index 0 désigne le moment de l'apparition du défaut, des fonctions $S_i(t)$, $S_1(t)$, $S_2(t)$ et $S_3(t)$, de manière correspondante aux relations ;

$$S_i(t) \;=\; \int_0^\tau \Delta i(\tau)d\tau$$

$$S_1(t) \;=\; \int_0^\tau \Delta u(\tau)d\tau$$

$$S_2(t) = \Delta u(t)$$

$$S_3(t) \;=\; \int_0^1\left(\int_0^\sigma \Delta u(\tau)d\tau\right)d\sigma\,.$$

26. Dispositif selon la revendication 25, **caractérisé en ce que**, dans l'unité d'évaluation, pour au moins une ramification ou un tronçon de ligne à surveiller du réseau, les coefficients $a_1$, $a_2$, et $a_3$ soient déterminés à partir du système d'équation linéaire de troisième ordre,

$$\underline{\underline{C}} \cdot \underline{a} = \underline{b}.$$

avec un vecteur solution $\underline{a}$ formé des trois coefficients $a_1$, $a_2$, et $a_3$, une matrice 3x3 $\underline{\underline{C}}$ et un vecteur tridimensionnelle $\underline{b}$, dont les éléments sont déterminés à partir des suites de valeurs calculées et mémorisées $S_i(n)$, $S_1(n)$, $S_2(n)$ et $S_3(n)$ par les relations suivantes,

$$c_{kj} \;=\; \sum_{n=i}^{N} S_k(n) \cdot S_j(n) \qquad \forall\; k,j \;\in\; \{1,2,3\}$$

et

$$b_k \;=\; \sum_{n=i}^{N} S_i(n) \cdot S_k(n) \qquad \forall\; k,j \;\in\; \{1,2,3\}\,,$$

et peuvent être calculées, **en ce qu'**on peut déterminer avec ces coefficients quelle est la ramification ou le tronçon de ligne surveillé correspondant sujet(te) à défaut.

27. Dispositif selon la revendication 20 ou 26, caractérisé en ce dans l'unité d'évaluation, on peut identifier comme défectueux une ramification ou un tronçon de ligne du réseau si les coefficients $a_1$ et/ou $a_2$ afférents sont négatifs ou inférieurs à un seuil prédéterminé, et l'on peut l'identifier comme exempt de tout défaut, si les coefficients $a_1$ et/ou $a_2$ afférents sont positifs ou supérieurs à un seuil prédéterminé.

28. Dispositif selon la revendication 27, **caractérisé en ce que** dans l'unité d'évaluation, on peut identifier un branchement ou une séparation d'une ramification ou d'un tronçon de ligne du réseau si toutes les valeurs de mesure $U_{ne}$ et $i_o^{(k)}$ de cette ramification ou tronçon de ligne k sont sensiblement de valeur zéro, avant ou après le moment de la manipulation de commutation.

29. Dispositif selon l'une des revendications 23 à 28, **caractérisé en ce que** la valeur de différence pour le courant homopolaire $\Delta i^{(k)}(n)$ de chaque ramification et tronçon de ligne à surveiller du réseau, et/ou la valeur de différence pour la tension de décalage de point neutre $\Delta u(n)$, est égale aux valeurs de mesure momentanées des courants homopolaires $i_o^{(k)}$ ou à la tension de décalage de point neutre $U_{ne}$ au moment nT.

$$\Delta i^{(k)}(n) := \left[i_o^{(k)}(n)\right]$$

avec $n \in \{0,1,2, ..., N\}$,

$$\Delta u(n) := \left[u_{ne}(n)\right].$$

**30.** Dispositif selon l'une des revendications 19 à 29, **caractérisé en ce que**, dans l'unité d'évaluation, on peut identifier la fin de l'état de défaut si une valeur effective ou une valeur absolue de la tension de décalage de point neutre $U_{ne}$ descend au-dessous d'un seuil d'exemption de défaut prédéfini.

**31.** Dispositif selon l'une des revendications 19 à 30, **caractérisé en ce que**, pour au moins une grandeur à mesurer, est prévue une mémoire électronique, de préférence organisée en anneau et de longueur M, pour mémoriser séquentiellement les valeurs de mesure numérisées, et **en ce que** l'on peut choisir, comme longueur M de la mémoire, un multiple entier du coefficient, formé de la fréquence de balayage $f_A$ et de la fréquence de réseau $f_N$.

**32.** Dispositif selon l'une des revendications 23 ou 31, **caractérisé en ce que** pour les valeurs de différence d'au moins une grandeur à mesurer, est prévue au moins une mémoire électronique, de préférence organisée en anneau, de longueur N, pour mémoriser séquentiellement les valeurs de différence.

**33.** Dispositif selon l'une des revendications 19 à 32, **caractérisé en ce que** l'unité d'évaluation est un microprocesseur.

Fig. 1

*Leitungsabschnitt*

EP 1 307 956 B1

Fig. 2

27